# EUROPÄISCHE PATENTSCHRIFT

(11) **EP 1 894 937 B1**
(45) Veröffentlichungstag und Bekanntmachung des Hinweises auf die Patenterteilung: **16.09.2009**
(21) Anmeldenummer: 07113162.7
(22) Anmeldetag: 26.07.2007
(51) Int. Cl.: C07F 9/00, H01L 21/285

(54) **Tantal- und Niob-Verbindungen und ihre Verwendung für die Chemical Vapour Deposition (CVD)**
Tantalum and niobium compounds and their application in Chemical Vapour Deposition (CVD)
Liaisons de tantale et de niobium et leur utilisation pour le dépôt chimique en phase vapeur (Chemical Vapour Deposition (CVD))

(30) Priorität: 12.08.2006 DE 102006037955
(43) Veröffentlichungstag der Anmeldung: 05.03.2008
(73) Patentinhaber: H.C. Starck GmbH, 38642 Goslar (DE)
(72) Erfinder: Reuter, Knud, 47800, Krefeld (DE); Kirchmeyer, Stefan, 51375, Leverkusen (DE); Gaess, Daniel, 35037, Marburg (DE); Pokoj, Michael, 35463, Fernwald (DE); Sundermeyer, Jörg, 35041, Marburg (DE); Stolz, Wolfgang, 35041, Marburg (DE); Ochs, Thomas, 35274, Kirchhein-Betziesdorf (DE); Volz, Kerstin, 35232, Dautphetal (DE)

(56) Entgegenhaltungen:
- EP-A- 1 757 612
- WO-A-00/65123
- GAESS, DANIEL ET AL: "Volatile Imido-Hydrazido Compounds of the Refractory Metals Niobium, Tantalum, Molybdenum, and Tungsten" INORGANIC CHEMISTRY (WASHINGTON, DC, UNITED STATES) , 46(16), 6688-6701 CODEN: INOCAJ; ISSN: 0020-1669, 2007, XP002456774
- DATABASE CA [Online] CHEMICAL ABSTRACTS SERVICE, COLUMBUS, OHIO, US; O'FLAHERTY, FERDIA P. ET AL: "The chemistry of niobium and tantalum dithiocarbamato-complexes. Part 2. Trimethylhydrazido(1-)-complexes: the reactivity and x-ray crystal structure of tris(diethyldithiocarbamato)[trimethylhydr azido (1-)-N,N']tantalum bromide-chloroform (1/1)" XP002456775 gefunden im STN Database accession no. 1990:470042 & JOURNAL OF THE CHEMICAL SOCIETY, DALTON TRANSACTIONS: INORGANIC CHEMISTRY (1972-1999) , (3), 1087-91 CODEN: JCDTBI; ISSN: 0300-9246, 1990,

## Beschreibung

Die vorliegende Erfindung betrifft spezielle, neue Tantal- und Niobverbindungen und deren Verwendung zur Abscheidung tantal- bzw. niobhaltiger Schichten mittels Chemical Vapor Deposition.

Ta- sowie Ta-N-basierende Mischsystemschichten für die Anwendung in der Si-Mikroelektronik werden gegenwärtig durch plasmabasierende Abscheideverfahren (Physical Vapour Deposition PVD) hergestellt. Im Hinblick auf die extremen Anforderungen für immer höher integrierte Schaltkreise, z.B. der konformen Schichtabscheidung auf strukturierten Oberflächen, gelangen die PVD-Verfahren zunehmend an die Grenzen der technischen Realisierbarkeit. Für diese Anwendungen werden verstärkt chemische Gasphasenabscheidungen (chemical Vapour Deposition CVD) bis hin zur Atomlagen-genauen Abscheidung mit einem Spezialverfahren der CVD, der sogenannten Atomic Layer Deposition (ALD), eingesetzt. Für diese CVD-Verfahren müssen naturgemäß für die jeweiligen gewünschten Schichten entsprechende chemische Ausgangsstoffe der einzelnen Elemente zur Verfügung stehen.

Zum gegenwärtigen Zeitpunkt werden für die CVD Ta-basierender Schichtstrukturen vorwiegend Halogenide, wie z.B. TaCl₅, TaBr₅, siehe WO 2000065123 A1, A. E. Kaloyeros et al., J. Electrochem. Soc. 146 (1999), S. 170-176, oder K. Hieber, Thin Solid Films 24 (1974), S.157-164) eingesetzt. Dies ist mit verschiedenen Nachteile behaftet. Zum einen sind Halogenradikale vielfach aufgrund ihrer ätzenden/korrodierenden Eigenschaften für den Aufbau komplexer Schichtstrukturen unerwünscht, andererseits haben die Tantalhalogenide Nachteile durch ihre geringe Flüchtigkeit und die schwierig Verarbeitbarkeit als hochschmelzende Feststoffe. Einfache Tantal-V-amide, wie z.B. Ta(N(CH₃)₂)₅, werden ebenfalls vorgeschlagen, siehe z. B. Fix et, al., Chem. Mater, 5 (1993), S. 614-619. Mit den einfachen Amiden lassen sich aber meist nur bestimmte Zerlegungsverhältnisse von Ta zu N einstellen, die eine genaue Kontrolle der einzelnen Elementkonzentrationen in den Schichten erschweren. Vielfach bilden sich Ta -V-Nitridfilme (siehe z. B. Fix ct al.: Ta₃N₅) und nicht die angestrebten elektrisch leitfähigen Ta-III-Nitridschichten (TaN). Zudem zeigen die mit diesen Ausgangsstoffen hergestellten Filme sehr oft hohe, unerwünschte Konzentrationen an Kohlenstoff. Tsai et. al., Appl. Phys. Lett. 67(8), (1995), S. 1128-1130 schlugen deshalb t-BuN=Ta(NEt₂)₃ in TaN-CVD bei 600 °C vor. Diese Verbindung bedarf wegen ihrer relativ geringen Flüchtigkeit einer hohen Anlagentemperatur und ist deshalb nicht sehr gut kompatibel mit den typischen Herstellungsprozessen integrierter Schaltkreise- Auch andere, ähnliche Tantalamidimide wurden vorgeschlagen, siehe z. B. Chiu et. al., J. Mat. Sci. Lett. 11 (1992), S. 96-98, womit jedoch ohne weiteres Reaktivgas hohe Kohlenstoffgehalte in den Tantalnitridschichten crzeugt wurden. In jüngerer Zeit wurden weitere Tantalnitrid-Prekursoren vorgeschlagen, z. B. durch Bleau et al., Polyhedron 24(3), (2005), S. 463-468, die wegen ihrer Komplexität und aufwändigen Herstellung von vornherein Nachteile aufweisen, oder spezielle Cyclopentadienylverbindungen, die entweder zwangsläufig zu TaSiN (nicht Tantalnitrid) führen oder einer zusätzlichen, nicht näher spezifizierten Stickstoffquelle bedürfen (Kamepalli et al., US Pat. Appl. Publ. 2004142555 A1, Prior. 2003-01-16, ATMI, Inc.). In US 6 593 484 (Kojundo Chemicals Laboratory Co., Ltd., Japan) wird ein geeignetes spezielles Tantalamidimid vorgeschlagen, wobei die angegebene Synthese jedoch schwierig und schlecht reproduzierbar ist. Fischer et al. beschreiben in Dalton Trans. 2006, 121 - 128 gemischte Hydrazido-Amido/Imido-Komplexe von Tantal, Hafnium und Zirkonium sowie deren Eignung in der CVD, jedoch ohne jegliche Angabe hinsichtlich des Ta:N-Verhältnisses im resultierenden Abscheideprodukt. In J. Chem. Soc. Dalton Trans. 1990, 1087 - 1091 wird ein Trichlorobis(trimethylhydrazidokomplex) beschrieben, jedoch fehlt jeglicher Hinweis auf dessen Verwendung in der CVD.

Somit ist ein erheblicher Bedarf nach weiteren, neuen Prekursoren für TaN-Schichten erkennbar, die die vorgenannten Nachteile nicht haben oder mindestens deutliche Verbesserungen bewirken. Für manche Anwendungen kann auch der Wunsch nach alternativen Prekursoren bestehen, die für die entsprechende Anwendung geeigneter sind.

Somit bestand die Aufgabe, die der vorliegenden Erfindung zugrunde lag, darin, solche Precursoren bereitzustellen.

Die Erfindung betrifft komplexe Tantalverbindungen mit zwei einwertigen Hydrazido-Liganden der Formel (I), die diese Voraussetzungen erfüllen. Die Hydrazidoliganden sind solche der allgemeinen Formel 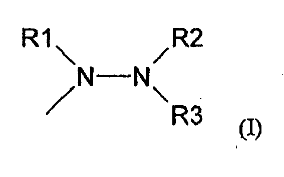 wobei
- R¹, R² und R³: unabhängig voneinander gegebenenfalls substituierte C₁- bis C₁₂-Alkyl-, jedoch nicht gleichzeitig Methyl, C₅- bis C₁₂-Cycloalkyl-, C₆- bis C₁₀-Aryl-Reste, 1-Alkenyl-, 2-Alkenyl-, 3-Alkenyl, Triorganosilylreste -SiR₃, worin R für einen C₁- bis C₄-Alkylrest steht, bedeuten.

Die Erfindung betrifft weiterhin die analogen Niob-Verbindungen, welche sich z. B. als CVD-Prekursoren für leitfähige Niob-Nitrid-Schichten (NbN) eignen.

Gegenstand der Erfindung sind Verbindungen der allgemeinen Formel (II), 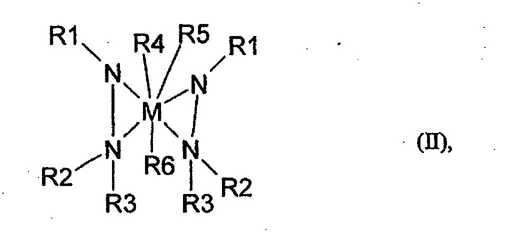 wobei
- M: für Nb oder Ta steht,
- R¹, R² und R³: unabhängig voneinander für gegebenenfalls substituierte C₁- bis C₁₂-Alkyl-, jedoch nicht gleichzeitig Methyl-, C₅- bis C₁₂-Cycloalkyl-, C₆- bis C₁₀-Aryl-Reste, 1-Alkenyl-, 2-Alkenyl-, 3-Alkenylreste, Triorganosilylreste -SiR₃, worin R für einen C₁- bis C₄-Alkylrest stehen,
- R⁴, R⁵, R⁶: für Halogen aus der Gruppe Cl, Br, I, für O-R⁸, worin R⁸ für einen gegebenenfalls substituierten C₁- bis C₁₂-Alkyl-, C₅- bis C₁₂-Cycloalkyl-, C₆- bis C₁₀-Aryl-Rest oder -SiR₃ steht, für BH₄, für einen gegebenenfalls substituierten Allyl-Rest, für einen Indenyl-Rest, für einen gegebenenfalls substituierten Benzyl-Rest, für einen gegebenenfalls substituierten Cyclopentadienyl-Rest, für CH₂SiMe₃, für ein Pseudohalogenid, wie z. B. -N₃, für Silylamid -N(SiMe₃)₂, für -NR⁹R¹⁰, wobei R⁹ und R¹⁰ unabhängig voneinander für gleiche oder verschiedene gegebenenfalls substituierte C₁- bis C₁₂-Alkyl-, C₅- bis C₁₂-Cycloalkyl-, C₆- bis C₁₀-Aryl-Reste, -SiR₃, wobei R für C₁-C₄-Alkyl steht, oder H stehen, oder für -NR¹-NR²R³ (Hydrazido(1)), wobei R¹, R² und R³ unabhängig voneinander die vorangehend genannte Bedeutung von R¹, R² und R³ haben, stehen
oder R⁴ und R⁵ gemeinsam für =N-R⁷ stehen, worin R⁷ für einen gegebenenfalls substituierten C₁- bis C₁₂-Alkyl-, C₅- bis C₁₂-Cycloalkyl- oder C₆- bis C₁₀-Aryl-Rest oder -SiR₃, steht.

Unter substituiert wird hier, wenn nicht anders erwähnt, eine Substitution mit C₁- bis C₄ - Alkoxy-oder Di (C₁- bis C₄ - Alkyl)amino-Resten verstanden.

Aus den erfindungsgemäßen Tantal- und Niobverbindungen können Tantal- und/oder Niob-haltige Metalle, Metalllegierungen, Oxide, Nitride und Carbide, sowie deren Mischungen und/oder Verbindungen in amorpher und/oder kristalliner Form, mittels CVD, ALD (Atomic Layer Deposition) und thermischer Zersetzung erzeugt werden. Anwendung finden derartige Mischungen und Verbindungen z. B. als dielektrische Schichten in Kondensatoren und Gates in Transistoren, Mikrowellenkeramiken, Piezokeramiken, thermischen und chemischen Barriereschichten, Diffusionsbarriereschichten, Hartstoffbeschichtungen, elektrisch leitfähigen Schichten, Antireflektionsschichten, optische Schichten und Schichten für IR-Spiegel. Ein Beispiel für optische Materialien sind Li-Tantalate und -Niobate. Beispiele für elektrisch leitfähige und korrosionsbeständige Schichten für Elektroden sind Tantal- und/oder Niob-haltige Titan- und Ruthenium-Mischoxide. Auch als Prekursoren für Flammpyrolysen zur Herstellung von Pulvern sind die erfindungsgemäßen Tantal-und Niobverbindungen geeignet.

Bevorzugt sind Verbindungen der allgemeinen Formel (III), 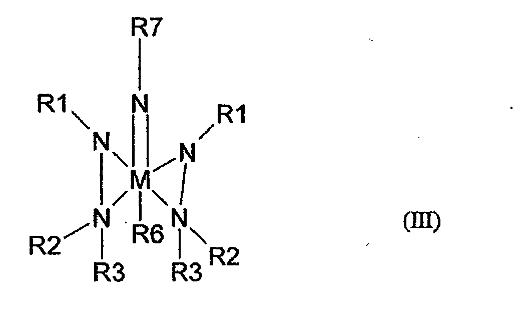 wobei
- M: für Ta oder Nb steht,
- R¹: für einen C₁- bis C₅-Alkyl-, C₅- bis C₆-Cycloalkyl- oder gegebenenfalls substituierten Phenyl-Rest, oder SiR₃ steht, wobei R für C₁-C₄-Alkyl steht,
- R² und R³: für gleiche C₁- bis C₅-Alkyl- oder C₅- bis C₆-Cycloalkyl-Reste oder gegebenenfalls substituierte Phenyl-Reste, oder SiR₃ stehen, wobei R für C₁-C₄-Alkyl steht,
- R⁷: für einen C₁- bis C₅-Alkyl-, C₅- bis C₆-Cycloalkyl- oder gegebenenfalls substituierten Phenyl-Rest, oder SiR₃ steht, wobei R für C₁-C₄-Alkyl steht, und
- R⁶: für einen Halogenrest aus der Gruppe Cl, Br, J, für BH₄, für einen gegebenenfalls substituierten Allyl-Rest, für einen Indenyl-Rest, für einen gegebenenfalls substituierten BenzylRest, für einen gegebenenfalls substituierten Cyclopentadienyl-Rest, für einen C₁- bis C₁₂-Oxyalkyl-Rest oder für einen Rest -NR⁹R¹⁰ steht, wobei R⁹ und R¹⁰ unabhängig voneinander für gleiche oder verschiedene gegebenenfalls substituierte C₁- bis C₁₂-Alkyl-, C₅- bis C₁₂-Cycloalkyl-, C₆- bis C₁₀-Aryl-Reste, -SiR₃, wobei R für C₁-C₄-Alkyl steht, oder H stehen.

Besonders bevorzugt werden dabei Verbindungen der allgemeinen Formel (IV), 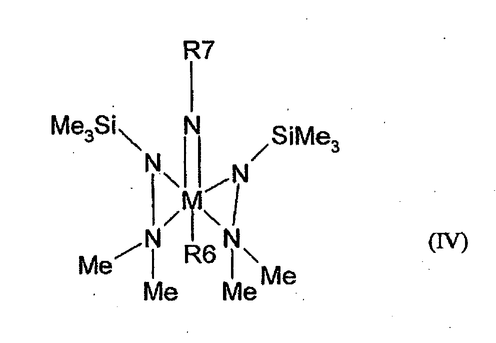 wobei
- R⁷: für einen Rest aus der Gruppe der C₁- bis C₅-Alkyl-Reste, einen gegebenenfalls durch eine bis drei C₁ bis C₅-Alkylgruppen substituierten C₆- C₁₀-Arylrest oder SiR₃ stehen, wobei R für C₁-C₄-Alkyl steht, und
- R⁶: für einen Halogenrest aus der Gruppe Cl, Br, J, für BH₄, für einen gegebenenfalls substituierter Allyl-Rest, für einen Indenyl-Rest, für einen gegebenenfalls substituierten BenzylRest, für einen gegebenenfalls substituierten Cyclopentadienyl-Rest, für einen C₁ bis C₁₂-Oxyalkyl-Rest oder für einen Rest -NR⁹R¹⁰ steht, wobei R⁹ und R¹⁰ unabhängig voneinander für gleiche oder verschiedene gegebenenfalls substituierte C₁- bis C₁₂-Alkyl-, C₅- bis C₁₂-Cycloalkyl-, C₆- bis C₁₀-Aryl-Reste, -SiR₃, wobei R für C₁-C₄-Alkyl steht, oder H stehen.

Ganz besonders bevorzugt sind Verbindungen der allgemeinen Formel (V) 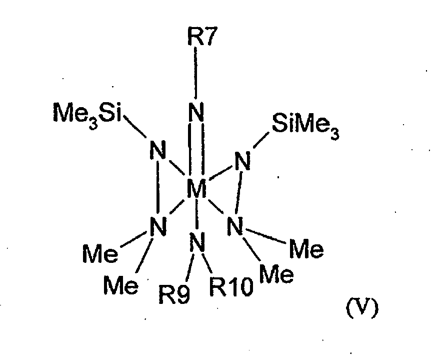 wobei
- R⁹ und W¹⁰: unabhängig voneinander für einen gleichen oder verschiedenen Rest aus der Gruppe der C₁- bis C₅-Alkyl-Reste, gegebenenfalls durch eine bis drei C₁ bis C₅-Alkylgruppen substituierte C₆- C₁₀-Arylreste, SiR₃, wobei R für C₁-C₄-Alkyl steht, oder H stehen und
- R⁷: für einen Rest aus der Gruppe der C₁- bis C₅-Alkyl-Reste, gegebenenfalls durch eine bis drei C₁ bis C₅-Alkylgruppen substituierte C₆- C₁₀-Arylreste oder SiR₃ steht, wobei R für C₁-C₄-Alkyl steht.

Ebenso ganz besonders bevorzugt sind Verbindungen der Formeln (VI) bis (X) 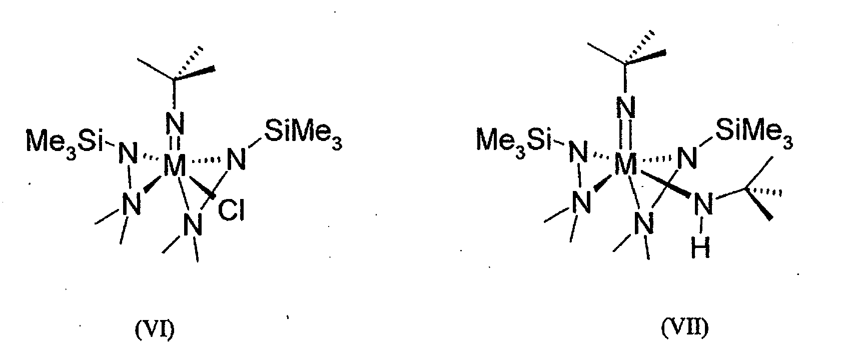 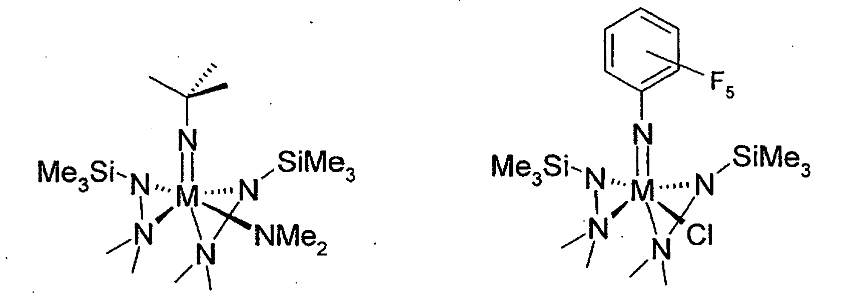 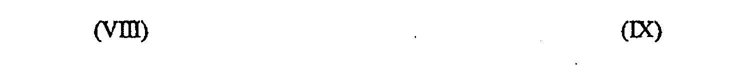 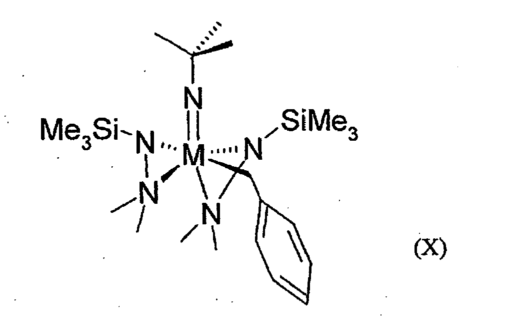 worin M für Ta oder Nb steht.

Ganz besonders bevorzugt sind jeweils die Tantal-Verbindungen (M = Ta).

**Alkyl** beziehungsweise **Alkoxy** steht jeweils unabhängig für einen geradkettigen, cyclischen oder verzweigten Alkyl- beziehungsweise Alkoxy-Rest, wobei die genannten Reste gegebenenfalls weiter substituiert sein können. Gleiches gilt für den Alkylteil eines Trialkylsilyl- bzw. Mono- oder Dialkylaminorestes oder den Alkylteil von Mono- oder Dialkylhydranzinen oder Mono-, Di-, Tri-oder Tetraalkylsilanen.

**C₁-C₄-Alkyl** steht im Rahmen der Erfindung beispielsweise für Methyl, Ethyl, n-Propyl, isoPropyl, n-Butyl, sec.-Butyl, tert.-Butyl, **C₁-C₅-Alkyl** darüber hinaus beispielsweise für n-Pentyl, 1-Methylbutyl, 2-Methylbutyl, 3-Methylbutyl, neo-Pentyl, 1-Ethylpropyl, 1,1-Dimethylpropyl, 1,2-Dimethylpropyl, 1,2-Dimethylpropyl, **C₁-C₆-Alkyl** darüber hinaus beispielsweise für n-Hexyl, 1-Methylpentyl, 2-Methylpentyl, 3-Methylpentyl, 4-Methylpentyl, 1,1-Dimethylbutyl, 1,2-Dimethylbutyl, 1,3-Dimethylbutyl, 2,2-Dimethylbutyl, 2,3-Dimethylbutyl, 3,3-Dimethylbutyl, 1-Ethylbutyl, 2-Ethylbutyl, 1,1,2-Trimethylpropyl, 1,2,2-Trimethylpropyl, 1-Ethyl-1-methylpropyl, 1-Ethyl-2-methylpropyl oder 1-Ethyl-2-methylpropyl, **C₁-C₁₂-Alkyl** darüber hinaus beispielsweise für n-Heptyl und n-Octyl, n-Nonyl, n-Decyl und n-Dodecyl.

**1-Alkenyl, 2-Alkenyl, 3-Alkenyl** steht beispielsweise für die den vorangehenden Alkylgruppen entsprechenden Alkenylgruppen. **C₁-C₄-Alkoxy** steht beispielsweise für die den vorangehenden Alkylgruppen entsprechenden Alkoxygruppen, wie z.B. Methoxy, Ethoxy, n-Propoxy, iso-Propoxy, n-Butoxy, sec.-Butoxy, tert.-Butoxy.

**C₅-C₁₂-Cycloalkyl** steht beispielsweise für gegebenenfalls substituierte mono-, bi- oder tricylische Alkylreste. Als Beispiele seien Cylopentyl, Cyclohexyl, Cycloheptyl, Pinanyl, Adamantyl, die isomeren Menthyle, n-Nonyl, n-Decyl, n-Dodecyl. Bevorzugt als **C₅-C₆-Cycloalkyl** sind Cylopentyl und Cyclohexyl.

**Aryl** steht jeweils unabhängig für einen aromatischen Rest mit 6 bis 14, bevorzugt 6 bis 10 Gerüstkohlenstoffatomen, in denen keines, ein, zwei oder drei Gerüstkohlenstoffatome pro Cyclus durch Heteroatome, ausgewählt aus der Gruppe Stickstoff, Schwefel oder Sauerstoff, substituiert sein können, vorzugsweise jedoch für einen carbocyclischen aromatischen Rest mit 6 bis 14, bevorzugt 6 bis 10 Gerüstkohlenstoffatomen.

Beispiele für gegebenenfalls substituierte **C₆-C₁₀-Aryl** sind Phenyl, 2,6-Diisopropylphenyl, o-, p-, m-Tolyl oder Naphthyl.

Weiterhin kann der carbocyclische aromatische Rest oder heteroaromatische Rest mit bis zu fünf gleichen oder verschiedenen Substituenten pro Cyclus substituiert sein, die ausgewählt sind aus der Gruppe Fluor, Cyano, C₁-C₁₂-Alkyl, C₁-C₁₂-Fluoralkyl, C₁-C₁₂-Fluoralkoxy, C₁-C₁₂-Alkoxy oder Di(C₁-C₈-alkyl)amino.

Die erfindungsgemäßen Verbindungen können auf einfache Weise hergestellt werden, indem Magnesium-Derivate von Hydrazido-Ligandenvorläufern der allgemeinen Formel (XI) 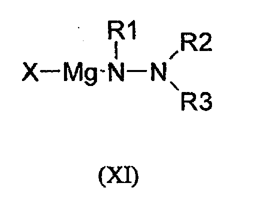 worin R¹, R², und R³ die vorangehend genannte Bedeutung haben, und X entweder ein Halogen aus der Gruppe Cl, Br, I oder ein Ligand der allgemeinen Formel (I) ist,
mit Ta- oder Nb-Komplexen der allgemeinen Formel (XII),

[M(R⁴)(R⁵)(R⁶)Cl₂L₂] (XII)

worin
- M: für Ta oder Nb steht,
- L: für einen Komplexliganden ausgewählt aus aliphatischen oder aromatischen Aminen, heterocyclischen Aminen, bevorzugt Pyridin, Ethern, "Halogenid, bevorzugt Chlorid, oder Nitrilen, bevorzugt Acetonitril steht, wobei L2 aber auch fehlern kann, und
R⁴, R⁵ und R⁶ die vorangehend genannte Bedeutung haben,
in einem geeigneten Lösungsmittel bevorzugt bei einer Temperatur von -20°C bis 120°C umgesetzt werden.

Geeignete Lösungsmittel sind beispielsweise Ether, wie z.B. THF, Diethylether oder 1,2-Dimethoxyethan, dipolar-aprotische Lösungsmittel, wie z.B. Acetonitril, N.N-Dimethylformamid oder tert.-Amine, halogenierte aliphatische bzw. aromatische Kohlenwasserstoffe, wie CH₂Cl₂, CHCl₃ oder Chlorbenzol, oder aliphatische oder aromatische Kohlenwasserstoffe, wie z.B. Toluol, Pentan, Hexan, etc., sowie Mischungen aus diesen oder Mischungen mit gegebenenfalls weiteren Lösungsmitteln. Die Ta- oder Nb-Komplexe der allgemeinen Formel (XII) [M(R⁴)(R⁵)(R⁶)Cl₂L₂] sind nach allgemein bekannten Verfahren in isolierter Form oder in-situ herstellbar.

An Stelle der Magnesiumverbindungen der Formeln (XI) können gegebenenfalls auch andere Metallderivate der Hydrazidoliganden, beispielsweise Alkalimetallsalze, z. B. des Lithiums, eingesetzt werden.

Ferner ist es möglich, erfindungsgemäße Hydrazidokomplexe durch Austausch von Liganden in andere erfindungsgemäße Verbindungen zu überfuhren. Beispielsweise kann dabei ein Iminoligand gegen einen anderen durch Umsetzung mit dem entsprechenden Amin ausgetauscht werden.

Schließlich können z. B. erfindungsgemäße, noch Halogenliganden enthaltende Hydrazidokomplexe mit Alkalisalzen von Aminen, wie beispielsweise Lithiumamide, in andere erfindungsgemäße Hlydrazidokomplexe überführt werden.

Zur Isolation der erfindungsgemäßen Verbindungen wird das Lösungsmittel beispielsweise mittels Abdestillieren unter vermindertem Druck entfernt, und es kann sich eine weitere Reinigung mittels Waschen sowie eine nachfolgende Trocknung anschließen. Solche geeigneten Verfahren sind dem Fachmann bekannt.

Weiterer Gegenstand der Erfindung ist die Verwendung von Verbindungen gemäß allgemeiner Formel (II) als Prekursor für Tantalnitrid-(TaN)-schichten bzw. Niobnitrid-(NbN)-schichten mittels Chemical Vapour Deposition. Bevorzugt sind Verbindungen der allgemeinen Formel (III), besonders bevorzugt sind Verbindungen der allgemeinen Formel (IV), ganz besonders bevorzugt sind Verbindungen der Formel (VI) bis (X) in diesen Verfahren einzusetzen. Die Definition der Reste entspricht hierbei den oben angegebenen Definitionen.

Die Verbindungen gemäß vorliegender Erfindung weisen die folgenden technischen Vorteile auf:
1) Die Einführung des Hydrazido-Liganden als CVD-geeignete Abgangsgruppe für Ta-III-oder Nb-III-Schichten reduziert die Gefahr eines unerwünschten C-Einbaus in die Substratbeschichtung.
2) In der Kombination mit N-Edukten, beispielsweise Hydrazin-Derivaten (1,1-Dimethylhydrazin, bzw. tert. Butylhydrazin) und Ammoniak ist bei der CGV D eine gezielte Veränderung der Schicht-Zusammensetzung möglich.
3) Durch Einsatz zweier Hydrazido-Liganden kann gezielt die Bildung des Oxidationszustandes des Ta bzw. Nb in der abgeschiedenen Schicht in Richtung Ta-III- bzw. Nb-III-Verbindungen gefördert werden.

Die Erfindung betrifft auch die Verwendung der erfindungsgemäßen Ta- und Nb-Verbindungen zur Abscheidung Ta- bzw. Nb-haltiger Schichten, gegebenenfalls unter Beimischung weiterer Verbindungen, zur definierten Einstellung bestimmter Konzentrationen der jeweiligen Elemente in der Schicht mittels Chemical Vapour Deposition (CVD) mit folgenden Verfahrensschritten: Ein geeignetes Substrat, wie z.B. eine Si-Scheibe oder auch eine bereits weitere oberflächenstrukturierte Einzel- oder Mehrfachschichten aufweisende Si-Scheibe, wie sie typischerweise für die Herstellung von Si-basierenden integrierten Schaltkreisen eingesetzt werden, wird in eine CVD-Anlage eingebracht und auf eine für die Schichtabscheidung geeignete Temperatur im Bereich von 250 °C bis 700 °C aufgeheizt. Ein Trägergas wird mit den Edukten in definierten Konzentrationen beladen, wobei inerte Gase wie z.B. N₂ und/oder Ar, auch in Kombination mit inerten, verdampften Lösungsmitteln wie z.B. Hexan, Heptan, Octan, Toluol oder Butylacetat als Trägergas eingesetzt werden können, und auch reaktive, z. B. reduzierende Gase, wie.z. B. H₂, zugesetzt werden können. Das beladene Trägergas wird für eine definierte Expositionsdauer über die Oberfläche des aufgeheizten Substrates geleitet, wobei die jeweiligen Konzentrationen an Edukten und die Expositionsdauer mit der Maßgabe aufeinander abgestimmt sind, dass eine Ta- bzw. Nb-haltige Schicht mit einer vorgegebenen Schichtdicke und einer vorgegebenen Zusammensetzung auf der Oberfläche des Substrats entweder amorph, nano- oder mikrokristallin bzw. polykristallin gebildet wird.

Typische Expositionsdauem sind je nach Abscheiderate beispielsweise wenige Sekunden bis hin zu mehreren Minuten oder Stunden. Typische Abscheideraten können beispielsweise von 0,1 nm/sec bis 1 nm/sec sein. Es sind jedoch auch andere Abscheideraten möglich. Typische Schichtdicken sind beispielsweise 0,1 bis 100 nm, bevorzugt 0,5 bis 50 nm, besonders bevorzugt 1 bis 10 nm.

Vorteilhafterweise werden im Rahmen der CVD-Technologie neben den Edukten gemäß allgemeiner Formel (II), bevorzugt allgemeiner Formeln (III) bis (X) zur Herstellung von reinen Ta- bzw. Nb-Metallschichten (Ta- bzw. Nb-reichen Einzelschichten), Ta- bzw. Nb-reichen Schichten als auch Ta-N- bzw. Nb-N-haltigen Mischschichten auch die folgenden Edukte zur gezielten Einstellung der N-Konzentration von Ta-N- bzw. Nb-N-haltigen Mischsystemschichten - auch nachfolgend N-Edukte genannt - eingesetzt: Ammoniak (NH₃), oder Mono(C₁-C₁₂-alkyl)hydrazine, insbesondere *tert*. Butylhydrazin (^{t}Bu-NH-NH₂), und/oder 1,1-Di(C₁-C₆-alkyl)hydrazine, insbesondere 1,1-Dimethylhydazin ((CH₃)₂N-NH₂), wobei die Alkylgruppen linear oder verzweigt sein können. Insbesondere zur Beeinflussung der Stabilität der hergestellten Mischsystemschichten in nachfolgenden Hochtemperaturausheizschritten kann es günstig sein, weitere Elemente in der CVD-Abscheidung beizumischen, um das Rekristallisationsverhalten der gebildeten Schicht zu beeinflussen. Für die Anwendung in Si-basierenden integrierten Schaltkreisen kommt hierfür besonders das Element Si in Frage. Vorteilhafterweise werden für die Herstellung von Ta(oder Nb)-N-Si-haltigen Mischsystemschichten neben den oben angesprochenen Edukten die folgenden Edukte für Si - auch nachfolgend Si-Edukte genannt - in der CVD-Technologie eingesetzt: Silan (SiH₄), und/oder Disilan (Si₂H₆), und/oder Mono(C₁-C₁₂-alkyl)silane, insbesondere *tert.*Butylsilan (tBu-SiH₃), und/oder Di(C₁-C₁₂-alkyl)silane, insbesondere Di-*tert*.butylsilan (tBu₂SiH₂), und/oder Tri(C₁-C₁₂-alkyl)silane, insbesondere Triethylsilan ((C₂H₅)₃SiH), und/oder Tetra(C₁-C₁₂-alkyl)silane, insbesondere Tetraethylsilan ((C₂H₅)₄Si), wobei die Alkylgruppen linear oder verzweigt sein können.

Grundsätzlich richten sich die genauen Konzentrationen der Edukte nach den thermischen Zerlegungseigenschaften der jeweiligen Edukte im CVD-Prozess. Vorzugsweise werden die Edukte in folgenden Mol-Verhältnissen eingesetzt: N-Edukt/Ta- bzw. Nb-Edukt 0 bis 20 000, Si-Edukte/Ta- bzw. Nb-Edukt 0-100. Die Oberflächentemperatur des Substrats wird bevorzugt im Bereich von 300 °C bis 600 °C eingestellt. Der Gesamtdruck von Trägergas und Edukten wird bevorzugt auf Drücke im Bereich von 10 hPa bis 1000 hPa eingestellt, wobei das Verhältnis des Partialdrucks der Summe aller Edukte zum Partialdruck des Trägergases zwischen 0,0001 bis 0,5 liegt. Die Abscheiderate bträgt vorzugsweise 0,05 nm/min bis 50 nm/min.

Die erfindungsgemäßen Tantal- und Niobverbindungen eignen sich auch als Prekursoren für Tantaloxid(Ta₂O₅)-Schichten bzw. Nioboxid(Nb₂O₅)-Schichten, die durch ihre hohen Dielektrizitätskonstanten für die Mikroelektronik interessant sind.

Die folgenden Beispiele dienen der beispielhaften Erläuterung der Erfindung und sind nicht als Beschränkung aufzufassen.

### Beispiele

In den nachfolgenden Beispielen bedeuten die Abkürzungen und abgekürzten Verbindungsnamen folgende Strukturen:

| | | | |
|---|---|---|---|
| ^{t}Bu | = | tert. Butyl | |
| ^{t}BuN | = | tert.Butylimino = | ^{t}Bu-N= |
| Me | = | Methyl | |
| Py | = | Pyridin | |
| Bz | = | Benzyl | |

### Beispiele zur Herstellung nicht erfindungsgemäßer Vorprodukte

### Vorprodukt Beispiel A: Herstellung von HN(SiMe₃)NMe₂.

60 ml (47 g, 0.78 mmol) 1,1-Dimethylhydrazin wurden in 500 ml Pentan vorgelegt und langsam mit 50 ml (43 g, 0.40 mmol) Chlortrimethylsilan versetzt. Nach vollständiger Zugabe wurde die Reaktionslösung für 3 Stunden am Rückfluss erhitzt und anschließend filtriert. Der Filtrationsrückstand wurde mit 60 ml Pentan gewaschen und die vereinigten Filtrate unter Argon destilliert. Die zweite Fraktion (99 °C) ergab 42,12 g (0,32 mmol; 81%) der farblosen Flüssigkeit.

¹H-NMR (300 MHz, CDCl₃): 2,22 ppm (6H, N(C*H*₃)₂), 1,78 ppm (1H, N*H*), -0,09 ppm (9H, Si(CH₃)₃). ¹³C{¹H} NMR (75 MHz, CDCl₃): 52,4 ppm (N(*C*H₃)₂), -0,8 ppm (Si(CH₃)₃). IR (Nujol-Mull, cm⁻¹): 3284 m, 2985 s, 2950 s, 2895 s, 2849 s, 2811 s, 2763 s, 1462 m, 1450 s, 1434 m, 1399 m, 1247 s, 1153 m, 1062 s, 1009 m, 895 s, 838 s, 747 m, 720 m, 685 m, 614 m, 493 m, 445 w

### Vorprodukt Beispiel B: Herstellung von [Mg(N(SiMe₃)NMe₂)Br].

4,21 g (173 mmol) Mg wurden in einem Dreihalskolben im Vakuum ausgeheizt und mit 600 ml Diethylether versetzt. 24,8 ml (31,2 g; 228 mmol) 2-Brombutan wurden tropfenweise durch ein Septum hinzugefügt. Nach Auflösen des Magnesiums wurden 23,0 g (174 mmol) HN(SiMe₃)NMe₂ hinzugetropft. Die Suspension wurde für 12 Stunden gerührt und bei 20 mbar auf 2/3 ihres Volumens eingeengt, bevor der farblose Feststoff abfiltriert und getrocknet wurde.

Ausbeute: 37,2 g (158 mmol; 91 %). IR (Nujol-Mull, cm⁻¹): 1249 m, 1242 m, 1012 m, 981 m, 871 m, 842 m, 771 m, 756 m, 673 m, 468 m

### Vorprodukt Beispiel C: Herstellung von [Mg(N(SiMe₃)NMe₂)Cl].

1,0 g (41,14 mmol) wurden in einem Dreihalskolben im Vakuum ausgeheizt und mit 60 ml Diethylether versetzt. 5,6 ml (4,9 g; 53,2 mmol) 1-Chlorbutan wurden durch ein Septum zugetropft. Nach Auflösung des Magnesiums wurden 5,8 g (43,8 mmol) HN(SiMe₃)NMe₂ tropfenweise durch ein Septum hinzugefügt Die Suspension wurde für 12 Stunden gerührt und bei 20 mbar auf 2/3 ihres Volumens eingeengt, bevor der farblose Feststoff abfiltriert und getrocknet wurde.

Ausbeute: 6,8 g (35,6 mmol; 87%). IR (Nujol-Mull, cm⁻¹): 1249 m, 1242 m, 1012 m, 981 m, 871 m, 842 m, 771 m, 756 m, 673 m, 468 m

### Vorprodukt Beispiel D: Herstellung von [Ta(^{t}BuN)(^{t}BuNH)Cl₂·2Py].

61,3 ml ^{t}BuNR₂ (587 mmol) in 50 ml CH₂Cl₂ wurden unter Eiskühlung zu einer Suspension von 21,0 g TaCl₅ (58,7 mmol) in 200 ml CH₂Cl₂ getropft. Danach wurde das Reaktionsgemisch auf 23 °C erwärmt und 4 h gerührt. Die erhaltene Suspension wurde erneut mit einem Eisbad gekühlt und eine Lösung von 23,7 ml (294 mmol) Pyridin in 50 ml CH₂Cl₂ hinzugegeben. Nach 4 h Rühren bei 23 °C wurden 150 m Hexan zum Reaktionsgemisch hinzugefügt und die erhaltene Lösung durch Celite filtriert. Der Rückstand wurde noch zweimal mit je 100 ml CH₂Cl₂/Hexan 1:1 bis zur Farblosigkeit gewaschen. Die vereinigten Lösungen wurden bei 20 mbar von allen flüchtigen Bestandteilen befreit, der Rückstand mit Hexan gewaschen und getrocknet Hellgelbes, mikrokristallines Produkt, Ausbeute 25,9 g (84 % d. Th.) Schmp. > 120 °C (Zers.).

### Elementaranalyse:

| | | | |
|---|---|---|---|
| Ber. (%) für C₁₈H₂₉N₄Cl₂Ta (M = 553,31 g·mol⁻¹): | C 39,07; | H 5,28; | N 10,13 |
| Gef. (%): | C 40,15; | H 5,17; | N 10,02 |

MS-EI: 379 (M⁺ - 2 Py - Me, 20 %), 323 (M⁺ - 2 Py - (CH₃)₂CCH₂ - Me, 42 %), 41 (100 %).
¹H-NMR (300,1 MHz, CDCl₃): δ = 1,28 (s, 9H, NHC(CH₃)₃), 1,31 (s, 9H, NC(CH₃)₃), 7,44 (*pseudo-*t, 4H, m-H_{py}), 7,86 (tt, J₁ = 7,7 Hz, J₂ = 1,5 Hz, 2H, p-Hpy), 8,60 (breites s, 1H, NHC(CH₃)₃), 9,40 (dd, J₁ = 6,9 Hz, J₂ = 1,5 Hz, 4H, o-H_{py})
¹³C{¹H}-NMR (CDCl₃, 75 MHz, 300 K): 32,3 (NC(*C*H₃)₃), 33,9 (NHC(*C*H₃)₃), 56,4 (NH*C*(CH₃)₃), 64,8 (s, N*C*(CH₃)₃), 124,1 (m-Py), 139,2 (p-Py), 153,5 (o-Py).

### Erfindungsgemäße Beispiele

### Beispiel 1: Herstellung von [Ta(N(SiMe₃)NMe₂)₂Cl₃]

5,2 g (9,94 mmol) [Ta(NtBu)Cl₃Py₂] (Vorprodukt Beispiel D) wurden in 30 ml CH₂Cl₂ vorgelegt und mit 2,9 g (21,86 mmol) HN(SiMe₃)NMe₂ (Vorprodukt Beispiel A) versetzt, bevor 10 Stunden gerührt wurde. Die orange Suspension wurde filtriert und der Rückstand mit 4 ml Toluol gewaschen. Die vereinten Filtrate wurden im Vakuum getrocknet und der Abdampfrückstand mit 100 ml Hexan digeriert. Dieser wurde abfiltriert und im Vakuum getrocknet

Ausbeute: 5,344 g (9,72 mmol, 97%). ¹H-NMR (300 MHz, C₆D₆): 3,08 ppm (6H, N(C*H*₃)₂), 0,17 ppm (9H, Si(C*H*₃)₃). ¹³C{¹H}-NMR (75 MHz, C₆D₆): 52,9 ppm (N(CH₃)₂), 0,17 ppm (Si(CH₃)₃). Elementaranalyse C₁₀H₃₀N₄Cl₃Si₂Ta: Theor.: C: 21,48; H: 5,50; N: 10,19. Gefunden: C: 10,42; H: 5,22; N: 10,42. EI-MS (Zuordnung, % relative Intensität): 550 [{M⁺}, 0,1], 417 [{M-(N(SiMe₃)NMe₂)}⁺, 25,5], 131 [{N(SiMe₃)NMe₂}⁺, 49,9]. IR (Nujol-Mull cm⁻¹): 1248 s, 1168 w, 1041 s, 1006 s, 910 s, 893 m, 844 s, 773 m, 734 m, 723 m, 696 m, 634 m, 501 s, 472 w

### Beispiel 2: Herstellung von [Ta(NtBu)(N(SiMe₃)NMe₂)₂Cl]

a) 4,0 g (7,7 mmol) [Ta(NtBu)Cl₃Py₂] (Vorprodukt Beispiel D) und 2,2 g (3,86 mmol) [Mg(N(SiMe₃)NMe₂)₂) wurden auf -78°C gekühlt, bevor 40 ml THF zugefügt wurden. Die Mischung wurde 4 Stunden gerührt und dann auf 23 °C gebracht. Nach 12 Stunden wurden die flüchtigen Bestandteile bei 20 mbar entfernt und der Rückstand mit 40 ml Hexan digeriert. Die Suspension wurde filtriert und der Rückstand mit zweimal 40 ml Hexan gewaschen. Die vereinten Filtrate wurden zur Trockne eingeengt und der Abdampfrückstand sublimiert (10⁻³ mbar, 70°C).
   Ausbeute: 3,53 g (6,42 mmol, 83 %)
B) 1,0 g (1,93 mmol) [Ta(NtBu)Cl₃Py₂] (Vorprodukt Beispiel D) und 740 mg (3,87 mmol) [Mg(N(SiMe₃)NMe₂)Cl] (Vorprodukt Beispiel C) wurden bei -78°C mit 10 ml THF versetzt. Die Reaktionsmischung wurde vier Stunden gerührt und dann auf 23 °C gebracht. Nach 12 Stunden wurde das Lösungsmittel entfernt und der Rückstand mit 30 ml Hexan extrahiert. Der Filtrationsrückstand wurde zweimal mit je 5 ml Hexan gewaschen und die vereinigten Filtrate im Vakuum zur Trockne gebracht. Der orange Rückstand wurde sublimiert (10⁻³ mbar, 70°C).
Ausbeute: 670 mg (1,22 mmol, 63 %). ¹H-NMR (300 MHz, C₆D₆): 2,69 ppm (6H, N(C*H*₃)₂), 2,46 ppm (6H, N(C*H*₃)₂), 1,40 ppm (9H, NC(C*H*₃)₃), 0,25 ppm (18H, Si(C*H*₃)₃). ¹³C{¹H} NMR (75 MHz, C₆D₆): 63,9 ppm (NC(CH₃)₃), 51,6 ppm (N(*C*H₃)₂), 51,1 ppm (N(CH₃)₂), 34,1 ppm (NC(CH₃)₃), 2,8 ppm (Si(CH₃)₃). Elementaranalyse: C₁₄H₃₉N₅ClSi₂Ta theor.: C: 30,57; H: 7,15; N: 12,73. Gef.: C: 29,70; H: 7,34; N: 12,03. EI-MS (Zuordnung, % relative Intensität): 549 [{M}⁺, 5,5], 534 [{M-CH₃}⁺, 100], 492 [({M-C₄H₉}⁺, 3,9], 131 [{(Me₃Si)NNMe₂}⁺, 18,6], 73 [{SiMe₃}⁺, 51,5], 58 [{NNMe₂}⁺ 9,9], 44 [{NMe₂}⁺, 2,4]. IR (Nujol-Mull, cm⁻¹): 1351 m, 1279 s, 1246 s, 1211 m, 1055 s, 1031 s, 902 s, 838 s, 785 m, 774 m, 715 m, 683 s, 634 m, 537 m, 480 s.

### Beispiel 3: Herstellung von [Nb(NtBu)(N(SiMe₃)NMe₂)₂Cl]

21,38 g (49.9 mmol) [Nb(NtBu)Cl₃Py₂] (hergestellt analog Vorprodukt Beispiel D) und 19,18 g (100,4 mmol) [Mg(N(SiMe₃)NMe₂)Cl] (Vorprodukt Beispiel C) wurden bei -78 °C mit 300 ml THF versetzt. Die Reaktionsmischung wurde nach vier Stunden auf 23 °C gebracht und weitere 8 Stunden gerührt. Die Suspension wurde zur Trockne eingeengt und mit 250 ml Hexan extrahiert. Der Filtrationsrückstand wurde mit zweimal 100 ml Hexan gewaschen und die vereinigten Filtrate bei 20 mbar von flüchtigen Bestandteilen befreit. Das orange Öl wurde destilliert (10⁻³ mbar, 130 °C).

Ausbeute: 17,3 g (37,4 mmol, 76 %).

¹H-NMR (300 MHz, C₆D₆): 2,65 ppm (6H, N(C*H*₃)₂), 2,53 ppm (6H, N(C*H*₃)₂), 1,30 ppm (9H, NC(C*H*₃)₃), 0,30 ppm (18H, Si(C*H*₃)₃). ¹³C{¹H}-NMR (75 MHz, C₆D₆): 65,8 ppm (NC(CH₃)₃), 52,9 ppm (N(CH₃)₂), 52,7 ppm (N(CH₃)₂), 35,5 ppm (NC(CH₃)₃), 2,9 ppm (Si(CH₃)₃). Elementaranalyse C₁₄H₃₉N₅ClSi₂Nb theor.: C: 36,39; H: 8,51; N: 15,16; gef.: C: 36,05; H: 8,38; N: 15,15. EI-MS (Zuordnung, % relative Intensität): 462 [{M}⁺, 0,1], 446 [{M-CH₃}⁺, 18,9], 403 [, 3,9], 132 [{H(Me₃Si)NNMe₂}⁺, 9,6], 131 [{(Me₃Si)NNMe₂}⁺, 14,6], 73 [{SiMe₃}⁺, 76,8], 59 [{HNNMe₂}⁺, 6,0], 58 [{NNMe₂}⁺, 12,5], 44 [{NMe₂}⁺, 29,8]. IR (Nujol-Mull, cm⁻¹): 1351 m, 1279 s, 1246 s, 1211 m, 1055 s, 1031 s, 902 s, 838 s, 785 m, 774 m, 715 m, 683 s, 634 m, 537 m, 480 s.

### Beispiel 4: Herstellung von [Ta(NtBu)(N(SiMe₃)NMe₂)₂Br]

33,5 g (64,8 mmol) [Ta(NtBu)Cl₃Py₂] (Vorprodukt Beispiel D) und 30,6 g (129,9 mmol) [Mg(N(SiMe₃)NMe₂)Br] (Beispiel B) wurden bei -50 °C mit 300 ml THF versetzt. Nach vier Stunden wurde auf 23 °C erwärmt und für weitere 10 Stunden gerührt. Die Suspension wurde bei 20 mbar von flüchtigen Bestandteilen befreit und mit 300 ml Hexan extrahiert. Der Filtrationsrückstand wurde zweimal mit je 200 ml Hexan gewaschen, bevor die vereinten Filtrate zur Trockne gebracht wurden. Der Abdampfrückstand wurde sublimiert (10⁻³ mbar, 70 °C).

Ausbeute: 26,04 g (43,8 mmol, 68 %), geringfügig verunreinigt.

¹H-NMR (300 MHz, C₆D₆): 2,70 ppm (6H, N(C*H*₃)₂), 2,46 ppm (6H, N(CH₃)₂), 1,41 ppm (9H, NC(*CH*₃)₃), 0,25 ppm (18H, Si(C*H*₃)₃), ¹³C{¹H}-NMR (75 MHz, C₆D₆): 63,9 ppm (N*C*(CH₃)₃), 51,6 ppm (N(CH₃)₂), 51,1 ppm (N(CH₃)₂), 34,1 ppm (NC(CH₃)₃), 2,8 ppm (Si(*C*H₃)₃). EI-MS (Zuordnung, % relative Intensität): 580 [{M-CH₃}⁺, 19,3], 131 [{(Me₃Si)NNMe₂}⁺, 18,6], 73 [{Si-Me₃}⁺, 51,5], 58 [{NNMe₂}⁺, 12,6], 44 [{NMe₂}⁺, 14,9].]. IR (Nujol-Mull, cm⁻¹): 1351 m, 1279 s, 1246 s, 1211 m, 1055 s, 1031 s, 902 s, 838 s, 785 m, 774 m, 715 m, 683 s, 634 m, 537 m, 480 s.

### Beispiel 5: Herstellung von [Nb(NtBu)(N(SiMe₃)NMe₂)₂Br]

150 mg (0,35 mmol) [Nb(NtBu)Cl₃Py₂] (hergestellt analog Vorprodukt Beispiel D) und 255 mg (1,08 mmol) [Mg(N(SiMe₃)NMe₂)Br] (Vorprodukt Beispiel B) wurden bei -78°C mit 5 ml THF versetzt und nach vier Stunden auf Raumtemperatur erwärmt. Nach 12 Stunden wurde zur Trockne eingeengt und mit 15 ml Hexan extrahiert. Der Filtrationsrückstand wurde mit zweimal 5 ml Hexan gewaschen und die Filtrate von flüchtigen Bestandteilen befreit. Das orange Öl wurde destilliert (10⁻³ mbar, 120 °C).

Ausbeute: 104 mg (0,21 mmol, 60 %). ¹H-NMR (300 MHz, C₆D₆): 2,65 ppm (6H, N(C*H*₃)₂), 2,54 ppm (6H, N(C*H*₃)₂), 1,27 ppm (9H, NC(C*H*₃)₃), 0,30 ppm (18H, Si(C*H*₃)₃). ¹³C{¹H}-NMR (75 MHz, C₆D₆): 66,3 ppm (NC(CH₃)₃), 53,5 ppm (N(CH₃)₂), 53,1 ppm (N(CH₃)₂), 32,3 ppm (NC(CH₃)₃), 2,9 ppm (Si(*C*H₃)₃). Elementaranalyse für C₁₄H₃₉N₅BrSi₂Nb theor.: C: 33,20; H: 7,76; N: 13,83; gef.: C: 32,88; H: 7,51; N: 13,78. EI-MS (Zuordnung, % relative Intensität): 492 [{M-CH₃}⁺, 10,4], 449 [{M-NNMe₂}⁺, 3,3], 131 [{(Me₃Si)NNMe₂}⁺, 30,9], 73 [{SiMe₃}⁺, 100,0], 58 [{NNMe₂}⁺, 17,7], 44 [{NMe₂}⁺, 52.0] IR (Nujol-Mull, cm⁻¹): 1351 m, 1279 s, 1246 s, 1211 m, 1055 s, 1031 s, 902 s, 838 s, 785 m, 774 m, 715 m, 683 s, 634 m, 537 m, 480 s.

### Beispiel 6: Herstellung von [Ta(NC₆F₅)(N(SiMe₃)NMe₂)₂Cl]

669 mg (1,21 mmol) [Ta(NtBu)(N(SiMe₃)NMe₂)₂Br] (Beispiel 4) und 224 mg (1,22 mmol) Pentafluoranilin wurden in 5 ml Hexan gelöst. Die Mischung wurde bei 60°C für 18 Stunden gerührt. Das Produkt wurde bei -20 °C aus der Reaktionslösung ausgefällt. Sukzessives Einengen und Ausfällen bei -20 °C ergab 620 mg (0,94 mmol, 77 %) des Produktes.

¹H-NMR (300 MHz, C₆D₆): 2,64 ppm (6H, N(C*H*₃)₂), 2,40 ppm (6H, N(C*H*₃)₂), 0,16 ppm (9H, Si(C*H*₃)₃). ¹³C{¹H}-NMR (75 MHz, C₆D₆): 51,5 ppm (N(CH₃)₂), 50,9 ppm (N(CH₃)₂), 2,0 ppm (Si(CH₃)₃}. ¹⁹F-NMR (282 MHz, C₆D₆): -135,9 ppm (psd, 2F, *o*-F), -167,0 (pst, 2F, *m*-F), -170,9 (pst, 1F, *p*-F). Elementaranalyse für C₁₆H₃₀N₅ClSi₂Ta theor.: C: 29,12; H: 4,58; N: 10,16 gef.: C: 28,23; H: 4,78; N: 9,81. EI-MS (Zuordnung, relative Intensität): 183 [{C₆F₅NH₂}⁺, 22,0], 131 [{N(SiMe₃)NMe₂}⁺, 1,0], 73 [{SiMe₃}⁺, 36,7], 44 [{NMe₂}, 53.9]. IR (Nujol-Mull, cm⁻¹): 1460 s, 1332 m, 1251 s, 1224 m, 1045 s, 1026 s, 983 m, 900 s, 841 s, 777 w, 751 w, 721 w, 684 w, 634 w, 482 w.

### Beispiel 7: Herstellung von [Nb(NC₆F₅)(N(SiMe₃)NMe₂)₂Cl]

1,5 g (3,2 mmol) [Nb(NtBu)(N(SiMe₃)NMe₂)₂Br] (Beispiel 5) wurden in 15 ml Toluol gelöst und zu 603 mg (3,2 mmol) Pentafluoranilin gegeben. Die Mischung wurde bei 60°C für 18 Stunden gerührt. Das Produkt wurde bei -20°C aus der Reaktionslösung ausgefällt. Sukzessives Einengen und Ausfällen bei -20°C ergab 1,02 g (1,79 mmol, 55 %) des Produktes.

¹H-NMR (300 MHz, C₆D₆): 2,64 ppm (6H, N(C*H*₃)₂), 2,45 ppm (6H, N(C*H*₃)₂), 0,22 ppm (9H, Si(C*H*₃)₃). ¹³C{¹H}-NMR (75 MHz, C₆D₆): 52,2 ppm (N(CH₃)₂), 51,8 ppm (N(CH₃)₂), 2,1 ppm (Si(CH₃)₃). ¹⁹F-NMR (282 MHz, C₆D₆): -152,8 ppm (psd, 2F, *o-*F), -166,4 (pst, 2F, *m*-F), -168,7 (pst, 1F, *p-*F). Elementaranalyse für C₁₆H₃₀N₅ClF₅Si₂Nb theor.: C: 33,60; H: 5,29; N: 12,24 gef.: C: 33,23; H: 5,08; N: 11,82. EI-MS (Zuordnung, % relative Intensität): 183 [{C₆F₅NH₂}⁺, 2,74], 131 [{N(SiMe₃)NMe₂}⁺, 6,15], 73 [{SiMe₃}⁺, 92,4], 44 [{NMe₂}, 58,9]. IR(Nujol-Mull, cm⁻¹): 1500 s, 1458 s, 1327 m, 1248 s, 1217 s, 1168 m, 1047 s, 985 s, 898 s, 839 s, 769 m, 720 m, 713 m, 680 m, 542 m, 499 m.

### Beispiel 8: Herstellung von [Ta(NtBu)(N(SiMe₃)NMe₂)₂Bz]

500 mg (0,84 mmol) [Ta(NtBu)(N(SiMe₃)NMe₂)₂Br] (Beispiel 4) und 127 mg (0,97 mmol) BzK wurden bei 0 °C mit 8 ml Toluol versetzt. Nach 1 Stunde wurde auf Raumtemperatur erwärmt und 17 Stunden gerührt. Die Suspension wurde im Vakuum getrocknet und mit 20 ml Hexan extrahiert. Das Filtrat wurde zur Trockne eingeengt und sublimiert (70 °C, 10⁻³ mbar).

Ausbeute: 465 mg (0,77 mmol, 91 %). ¹H-NMR (300 MHz, C₆D₆): 7,53 ppm (d, 2H, *o*-H), 7,28 ppm (t, 2H, *m*-H), 6,94 ppm (t, 1H, *p*-H), 2,41 (s, 2H, Ph-*CH*₂-Ta), 2,35 ppm (s, 12H, N(C*H*₃)₂), 1,44 ppm (s, 9H, NC(C*H*₃)₃), 0,24 ppm (s, 9H, Si(C*H*₃)₃). ¹³C{¹H}-NMR (75 MHz, C₆D₆): 153,5 ppm (Bz), 128,9 ppm (Bz), 121.2 ppm (Bz), 63,6 ppm (N*C*(CH₃)₃), 51,2 ppm (N(CH₃)₂), 50,8 ppm (N(CH₃)₂), 49,7 ppm (Ph-CH₂-Ta), 3,0 ppm (Si(CH₃)₃). Elementaranalyse für C₂₁H₄₆N₅Si₂Ta theor.: C: 41,64; H: 7,65; N: 11,56 gef.: C: 41,03; H: 7,34; N: 10,83. EI-MS (Zuordnung, % relative Intensität): 514 [{M-C₇H₇}⁺, 100,0], 471 [{M-C₇H₇-NMe₂}⁺, 6,6], 91 [{C₇H₇}⁺, 23,3], 73 [{Si-Me₃}⁺, 26,1], 58 [{NNMe₂}, 7,8]. IR (Nujol- Mull, cm⁻¹): 3059 w, 1596 m, 1485 w, 1351 w, 1275 s, 1246 s, 1209 m, 1053 s, 1026 s, 898 s, 838 s, 743 m, 716 w, 697 m, 480 m.

### Beispiel 9: Herstellung von [Nb(NtBu)(N(SiMe₃)NMe₂)₂Bz]

1,57 g (3,3 mmol) [Nb(NtBu)(N(SiMe₃)NMe₂)₂Br] (Beispiel 5) wurden mit einer Lösung aus 512 mg (3,9 mmol) BzK in 15 ml Toluol bei 0°C versetzt. Nach einer Stunde wurde auf Raumtemperatur erwärmt und 17 Stunden lang gerührt. Die flüchtigen Bestandzeile wurden bei 20 mbar entfernt und der Abdampfrückstand mit 20 ml Hexan extrahiert. Das Filtrat wurde eingeengt und das Produkt bei -20 °C ausgefällt. Ausbeute: 1,43 g (2,77 mmol, 81 %). Zur weiteren Reinigung kann das Produkt bei 90°C (10⁻³ mbar) sublimiert werden.

¹H-NMR (300 MHz, C₆D₆): 7,50 ppm (pseudo-d, ³J_{H,H} = 7,2 Hz, 2H, *o*-H), 7,25 ppm (t, 2H, ³J_{H,H} = 7,5 Hz, *m*-H), 6,94 ppm (t, 1H, ³J_{H,H} = 7,2 Hz, *p*-H), 2,71 (s, 2H, Ph-CH₂), 2,37 ppm (s, 6H, N(CH₃)₂), 2,34 ppm (s, 6H, N(C*H*₃)₂), 1,37 ppm (s, 9H, NC(C*H*₃)₃), 0,26 ppm (s, 9H, Si(C*H*₃)₃). ¹³C{¹H}-NMR (126 MHz, C₆D₆): 154,3 ppm (*i*-Bz), 128,4 ppm (*o-*Bz), 127,8 ppm (*m*-Bz), 120,6 ppm (*p*-Bz), 64.3 ppm (NC(CH₃)₃), 51,6 ppm (N(CH₃)₂), 51,5 ppm (N(CH₃)₂), 44,3 ppm (-CH₂-, sehr breit), 33,3 ppm (NC(CH₃)₃), 3,1 ppm (Si(CH₃)₃). Elementaranalyse für C₂₁H₄₆N₅Si₂Nb theor.: C: 48,72; H: 8,96; N: 13,53 gef.: C: 48,57; H: 8,87; N: 13,39. EI-MS (Zuordnung, % relative Intensität): 514 [{M-C₇H₇}⁺, 100,0], 471 [{M-C₇H₇-NMe₂}⁺, 6,6], 91 [(C₇H₇}⁺, 23,3], 73 [{SiMe₃}⁺, 26,1], 58 [{NNMe₂}, 7,8]. IR (Nujol-Mull, cm⁻¹): 2822 m, 2776 m, 1396 m, 1352 m, 1249 s, 1213 m, 1134 m, 1055 s, 1033 s, 964 s, 896 s, 839 s, 773 m, 748 m, 681 m, 634 w, 575 w, 527 m, 481 m.

### Beispiel 10: Herstellung von [Ta(NtBu)(N(SiMe₃)NMe₂)₂(NMe₂)]

Eine Mischung aus 30,32 g (50,9 mmol) [Ta(NtBu)(N(SiMe₃)NMe₂)₂Br] (Beispiel 4) und 2,86 g (56,1 mmol) LiNMe₂ wurde bei 0 °C mit 300 ml Toluol versetzt. Nach einer Stunde wurde für 10 Stunden bei 23 °C gerührt. Die Reaktionsmischung wurde filtriert und der Rückstand mit 150 ml Hexan gewaschen. Die vereinten Filtrate wurden zur Trockne eingeengt und der Rückstand sublimiert (90 °C, 10⁻³ mbar).

Ausbeute: 24,86 g (44,5 mmol, 87 %). ¹H-NMR (300 MHz, C₆D₆): 3,43 ppm (s, 6H, Ta-N(*CH*₃)₂), 2,53 ppm (s, 6H, N(CH₃)₂), 2,40 ppm (s, 6H, N(*CH*₃)₂), 1,50 ppm (s, 9H, NC(C*H*₃)₃), 0,34 ppm (s, 9H, Si(C*H*₃)₃), ¹³C{¹H}-NMR (75 MHz, C₆D₆): 63,2 ppm (NC(CH₃)₃), 51,6 ppm (Ta-N(CH₃)₂), 51,3 ppm (N(CH₃)₂), 50,5 ppm (N(CH₃)₂), 35,0 ppm (NC(*C*H₃)₃), 3,5 ppm (Si(CH₃)₃). Elementaranalyse für C₁₆H₄₅N₆Si₂Ta theor.: C: 34,40; H: 8,12; N: 15,04. Found: C: 34,27; H: 7,92; N: 15,14. EI-MS (Zuordnung, % relative Intensität): 558 [{M}⁺, 5,5], 543 [{M-CH₃}⁺, 50,5], 501 [{M-C₄H₉}⁺, 33,3], 132 [{HN(SiMe₃)NMe₂}⁺, 15,0], 131 [(N{SiMe₃)NMe₂}⁺, 9,0], 73 [{SiMe₃}⁺, 100,0], 58 [{NNMe₂}, 54,1], 44 [{NMe₂}, 20.5]. IR (Nujol-Mull, cm⁻¹): 2810 s, 2758 s, 1350 m, 1275 s, 1244 s, 1211 m, 1157 m, 1053 s, 1031 s, 964 s, 895 s, 837 s, 775 s, 717 m, 682 s, 634 m, 540 s, 474 m.

### Beispiel 11: Herstellung einer erfindungsgemäßen Ta-haltigen CVD-Schicht

Nach üblicher Vorbehandlung wurde eine Si-Scheibe (Hersteller: Wacker, Virginia Semiconductor oder G-Material) in eine CVD-Apparatur (Typ Aix 200 des Herstellers Aixtron AG) eingesetzt. Zunächst erfolgte in üblicher Weise ein thermischer Ausheizschritt der Si-Scheibe zu Reinigungszwecken bei 750°C in einem inerten Trägergasstrom. Danach wurde die Scheibe auf eine Substrattemperatur von 500°C abgekühlt. Auf die so erhaltene Oberfläche wurde eine Schicht aus den erfindungsgemäßen Ta-Ausgangssubstanzen abgeschieden. Hierzu wurde ein Inertgasstrom aus N₂ mit den verschiedenen Edukten beladen. Als Edukte wurden eingesetzt: [Ta{NtBu)(N(SiMe₃)NMe₂)₂{NMe₂)] (Beispiel 10) und 1,1-Dimethylhydrazin, wobei das 1,1-Dimethylhydrazin kommerziell in der für die CVD geeigneten Reinheit erhältlich ist (beispielsweise von Akzo Nobel HPMO).

Für die Herstellung erfindungsgemäßer Ta-haltiger Schichten wurden beispielhaft die folgenden Bedingungen bei einem Gesamtdruck des CVD-Reaktors von 100 hPa gewählt: 0,00005 hPa [Ta(NtBu)(N(SiMe₃)NMe₂)₂(NMe₂)] (Beispiel 10), 3 hPa 1,1-Dimethylhydrazin. Das N/Ta-Verhältnis wurde somit zu.60000 gewählt. Der beladene N₂-Trägergasstrom mit einem Gesamtdruck von 100 hPa wurde sodann für die Dauer von 4 h über die auf 500°C erwärmte Oberfläche der Si-Scheibe geleitet. Es wurde eine erfindungsgemäße Schicht mit einer Dicke von 85 nm erhalten. Nach Ablauf der Expositionsdauer wurde die CVD-Anlage auf die Abscheidebedingungen einer gewünschten weiteren Schicht umgestellt, oder die Schicht wurde unter einem inerten Trägergasstrom abgekühlt und dem CVD-Reaktor entnommen.

### Beispiel 12: Herstellung von [Nb(NtBu)(N(SiMe₃)NMe₂)₂(NMe₂)]

Zu 1,5 g (3,2 mmol) [Nb(NtBu)(N(SiMe₃)NMe₂)₂Br] (Beispiel 5) wurde eine Lösung von 164 mg (3,3 mmol) LiNMe₂ in 15 ml Toluol bei 0 °C gegeben. Nach einer Stunde wurde für 10 Stunden bei 23 °C gerührt. Die Reaktionsmischung wurde filtriert und der Abdampfrückstand der Filtrate sublimiert (100 °C, 10⁻³ mbar).

Ausbeute: 1,12 g (2,4 mmol, 73 %). ¹H-NMR (300 MHz, C₆D₆): 3,40 ppm (s, 6H, Ta-N(C*H₃*)₂), 2,51 ppm (s, 6H, N(C*H*₃)₂), 2,41 ppm (s, 6H, N(C*H*₃)₂), 1,46 ppm (s, 9H, NC(C*H*₃)₃), 0,34 ppm (s, 9H, Si(C*H*₃)₃). ¹C{1H}-NMR (75 MHz, C₆D₆): 52,0 ppm (Ta-N(CH₃)₂), 51,2 ppm (N(CH₃}₂), 50,57 ppm (N(CH₃)₂), 33,7 ppm (NC(CH₃)₃), 3,5 ppm (Si(CH₃)₃). EI-MS (Zuordnung, % relative Intensität): 470 [{M)⁺, 1,7], 412 [{M-NN(CH₃)₂}⁺, 5,7], 367 [{M-NN(CH3)2-HN(CH₃)₂}⁺, 33,3], 132 [{HN{SiMe₃)NMe₂}⁺, 3,0, 131 [{N(SiMe₃)NMe₂}⁺, 3,0], 73 [{SiMe₃}⁺, 48,9], 58 [{NNMe₂), 54,1], 44 [{NMe₂}, 20,5]. Elementaranalyse für C₁₆H₄₅N₆Si₂Ta theor.: C: 34,40; H: 8,12; N: 15,04 gef.: C: 40,37; H: 9,55; N: 17,74. IR (Nujol-Mull, cm⁻¹): 2754 s, 1352 w, 1247 s, 1210 w, 1155 w, 1131 w, 1053 s, 1032 s, 958 s, 892 s, 837 s, 777 m, 716 m, 681 m, 634 w, 552 w, 476 w.

### Beispiel 13: Herstellung von [Ta(NtBu)(N(H)tBu)(N(SiMe₃)NMe₂)₂]

a) 306 mg (0,54 mmol) [Ta(NtBu)(N(SiMe₃)NMe₂)₂Br] (Beispiel 4) und 55 mg (0,69 mmol) LiN(H)tBu wurden mit 5 ml Toluol bei 0 °C versetzt. Nach 30 Minuten wurde auf 23 °C gebracht und weitere 10 Stunden gerührt. Die Suspension wurde filtriert und der Rückstand mit 5 ml Hexan gewaschen. Die vereinten Filtrate wurden zur Trockne eingeengt und sublimiert (100 °C, 10⁻³ mbar). Ausbeute: 220 mg (0,36 mmol, 67%).
b) 4,0 g (7,23 mmol) [Ta(NtBu)(N(H)tBu)Cl₂Py₂] (Beispiel D) und 3,4 g (14,44 mmol) [Mg(N(SiMe₃)NMe₂)Br] (Beispiel B) wurden bei -78°C mit 20 mal THF versetzt. Nach einer Stunde wurde auf Raumtemperatur erwärmt und für weitere 12 Stunden gerührt. Die Suspension wurde bei 20 mbar von flüchtigen Bestandteilen befreit und der Rückstand mit 40 ml Hexan extrahiert. Der Filtrationsrückstand wurde zweimal mit 10 ml Hexan gewaschen. Die vereinten Filtrate wurden zur Trockne eingeengt und sublimiert (100°C, 10⁻³ mbar).

Ausbeute: 2,77 g (4,72 mmol, 65 %). ¹H-NMR (300 MHz, C₆D₆): 3,00 (s, 1H, *H*NtBu), 2,60 ppm (s, 6H, N(C*H*₃)₂), 2,.35 ppm (s, 6H, N(C*H*₃)₂), 1,54 ppm (s, 9H, NC(C*H*₃)₃), 1,52 ppm (s, 9H, NC(C*H₃*)₃), 0,32 ppm (s, 9H, Si(C*H*₃)₃). ¹³C{1H}-NMR (75 MHz, C₆D₆): 63,4 ppm (N*C*(CH₃)₃), 52,8 ppm (N*C*(CH₃)₃), 50.4 ppm (Ta-N(CH₃)₂), 49.7 ppm (N(CH₃)₂), 35.8 ppm (NC(CH₃)₃), 35.1 ppm (NC(CH₃)₃), 3,4 ppm (Si(CH₃)₃). EI-MS (Zuordnung, % relative Intensität): 529 [{M-C₄H₉}⁺, 9,7], 131 [{N(SiMe₃)NMe₂}⁺, 20,6], 73 [{SiMe₃}⁺, 100,0], 57 [{C₄H₉}⁺, 8,8], 44 [{NMe₂}, 47,0]. Elementaranalyse für C₁₈H₄₉N₆Si₂Ta theor.: C: 36,85; H: 8,42; N: 14,32 gef.: C: 14,26; H: 8,34; N: 14,31. IR (Nujol-Mull, cm⁻¹): 2724 w, 1351 w, 1271 s, 1245 s, 1211 m, 1052 s, 1029 s, 979 m, 896 s, 837 s, 774 m, 724 bm, 682 m, 530 w, 475 w.

### Beispiel 14: Herstellung von (Nb(NtBu)(N(H)tBu)(N(SiMe₃)NMe₂)₂]

a) Eine Mischung aus 1,52 g (3,29 mmol) [Nb(NtBu)(N(SiMe₃)NMe₂)₂Br] (Beispiel 5) und 256 mg (3,21 mmol) LiN(H)tBu wurde bei 0 °C mit 15 ml Toluol versetzt. Nach 30 Minuten wurde auf 23 °C erwärmt und für 10 Stunden gerührt. Die Suspension wurde filtriert und der Rückstand mit zweimal 5 ml Hexan gewaschen. Die Filtrate wurden vereinigt und zur Trockne gebracht. Der Abdampfrückstand wurde sublimiert (100°C, 10⁻³ mbar). Ausbeute: 1,08 g (2,16 mmol, 67 %).
b) 10,0 g (21,6 mmol) [Nb(NtBu)(N(H)tBu)Cl₂Py₂] (hergestellt analog Beispiel D) und 10,1 g (43,0 mmol) [Mg(N(SiMe₃)NMe₂)Br] (Beispiel B) wurden bei -78 °C mit 200 ml THF versetzt.

Nach einer Stunde wurde auf 23°C gebracht und für 12 Stunden gerührt. Die Suspension wurde zur Trockne eingeengt und mit 200 ml Hexan extrahiert. Der Rückstand wurde zweimal mit 50 ml Hexan gewaschen. Die vereinigten Filtrate wurden bei 20 mbar von flüchtigen Bestandteilen befreit und sublimiert (100 °C, 10⁻³ mbar).

Ausbeute: 7,56 g (15,1 mmol, 70 %). ¹H-NMR (300 MHz, C₆D₆): 3,67 (s, 1H, *H*NtBu), 2,57 ppm (s, 6H, N(C*H*₃)₂),2,36 ppm (s, 6H, N(C*H*₃)₂), 1,53 ppm (s, 9H, NC(CH₃)₃), 1,48 ppm (s, 9H, NC(C*H*₃)₃), 0,34 ppm (s, 9H, Si(C*H*₃)₃). ¹³C{1H]-NMR (75 MHz, C₆D₆): 50,4 ppm (N*C*(CH₃)₃), 50,4 ppm (Ta-N(CH₃)₂), 49,9 ppm (N(*C*H₃)₂), 35,6 ppm (NC(*C*H₃)₃), 33,8 ppm (NC(CH₃)₃), 3,4 ppm (Si(*C*H₃)₃); die Signale der tertiären C-Atome sind wegen der extremen Verbreiterung nicht genau zu lokalisieren (ca. 63,5 ppm). EI-MS (Zuordnung, % relative Intensität): 498 [{M}⁺, 1,3], 483 [{M-CH₃}⁺, 0,1], 440 [{M-N₂C₂H₆}⁺, 13,9], 426 [{M-CH₃-C₄H₉}⁺, 18,1], 367 [{M-N(SiMe₃}NMe₂}⁺, 8,1], 351 [{M-HN(SiMe₃)NMe₂-CH₃}⁺, 3,7], 236 [{M-2N(SiMe₃)NMe₂}⁺, 3,2], 235 [{M-N(SiMe₃)NMe₂-HN(SiMe₃)NMe₂]⁺, 4,9], 132 [{HN(SiMe₃)NMe₂}⁺, 4,4], 131 [{N(SiMe₃)NMe₂}⁺, 6,7], 73 [(SiMe³}⁺, 65,4], 58 [{N₂Me₂}⁺, 60,0], 45 [{HNMe₂}⁺, 1,9]. Elementaranalyse für C₁₈H₄₉N₆Si₂Nb theor.: C: 43;35; H: 9;90; N: 16;85. gefunden: C: 42;78; H: 9;99; N: 16;41. IR (Nujol-Mull, cm⁻¹): 2725 w, 1352 w, 1246 s, 1210 m, 1053 s, 1029 s, 975 w, 892 s, 837 s, 773 m, 717 m, 681 w, 533 w, 477 w.

## Patentansprüche

1. Verbindungen der allgemeinen Formel (II), 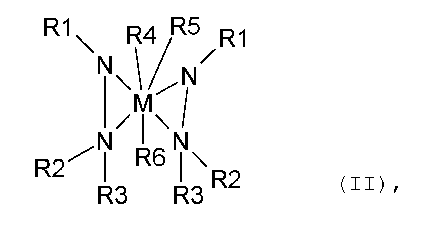 wobei
M für Nb oder Ta steht,
R¹, R² und R³ unabhängig voneinander für einen gegebenenfalls substituierten C₁- bis C₁₂-Alkyl-, jedoch nicht gleichzeitig Methyl, C₅- bis C₁₂-Cycloalkyl-, C₆- bis C₁₀-Aryl-, 1-Alkenyl-, 2-Alkenyl-, 3-Alkenylrest oder Triorganosilylrest -SiR₃ stehen, worin R für einen C₁- bis C₄-Alkylrest steht,
R⁴, R⁵, R⁶ für Halogen aus der Gruppe Cl, Br, I, für O-R⁸, worin R⁸ für einen gegebenenfalls substituierten C₁- bis C₁₂-Alkyl-, C₅- bis C₁₂-Cycloalkyl-, C₆- bis C₁₀-Aryl-Rest oder -SiR₃ steht, für BH₄, für einen gegebenenfalls substituierten Allyl-Rest, für einen Indenyl-Rest, für einen gegebenenfalls substituierten Benzyl-Rest, für einen gegebenenfalls substituierten Cyclopentadienyl-Rest, für CH₂SiMe₃, für ein Pseudohalogenid, wie z. B. -N₃, für Silylamid -N(SiMe₃)₂, für -NR⁹R¹⁰, wobei R⁹ und R¹⁰ unabhängig voneinander für gleiche oder verschiedene gegebenenfalls substituierte C₁- bis C₁₂-Alkyl-, C₅- bis C₁₂-Cycloalkyl-, C₆- bis C₁₀-Aryl-Reste, -SiR₃, wobei R für **C₁-C₄-Alkyl steht,** oder H stehen, oder für -NR¹-NR²R³ (Hydrazido(1)), wobei R¹, R² und R³ unabhängig voneinander die vorangehend genannte Bedeutung von R¹, R² und R³ haben, stehen
oder R⁴ und R⁵ gemeinsam für =N-R⁷ stehen, worin R⁷ für einen gegebenenfalls substituierten C₁- bis C₁₂-Alkyl-, C₅- bis C₁₂-Cycloalkyl- oder C₆- bis C₁₀-Aryl-Rest oder -SiR₃, steht.

2. Verbindungen gemäß Anspruch 1, **dadurch gekennzeichnet, dass** es solche der allgemeinen Formel (III) sind, 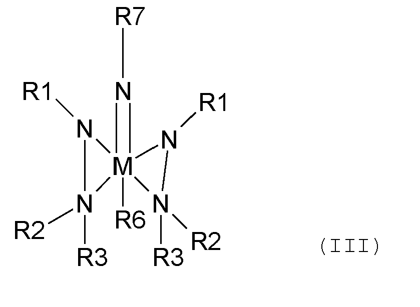 wobei
M für Ta oder Nb steht,
R¹ einen C₁- bis C₅-Alkyl-, C₅- bis C₆-Cycloalkyl-oder gegebenenfalls substituierten Phenyl-Rest, oder SiR₃, wobei R für **C₁-C₄-Alkyl steht,**
R² R⁴ und R⁵ und R³ für gleiche C₁- bis C₅-Alkyl- oder C₅- bis C₆-Cycloalkyl-Reste oder gegebenenfalls substituierte Phenyl-Reste, oder SiR₃, wobei R für **C₁-C₄-Alkyl** steht, stehen
R⁷ einen C₁- bis C₅-Alkyl-, C₅- bis C₆-Cycloalkyl-oder gegebenenfalls substituierten Phenyl-Rest, oder SiR₃, wobei R für **C₁-C₄-Alkyl steht, und**
R⁶ für einen Halogenrest aus der Gruppe Cl, Br, J, für BH₄, für einen gegebenenfalls substituierter Allyl-Rest, für einen Indenyl-Rest, für einen gegebenenfalls substituierten Benzyl-Rest, für einen gegebenenfalls substituierten Cyclopentadienyl-Rest, für einen C₁- bis C₁₂-Oxyalkyl-Rest oder für einen Rest -NR⁹R¹⁰ steht, wobei R⁹ und R¹⁰ unabhängig voneinander für gleiche oder verschiedene gegebenenfalls substituierte C₁-bis C₁₂-Alkyl-, C₅- bis C₁₂-Cycloalkyl-, C₆- bis C₁₀-Aryl-Reste, -SiR₃, wobei R für **C₁-C₄-Alkyl steht**, oder H stehen.

3. Verbindungen gemäß Anspruch 1 oder 2, **dadurch gekennzeichnet, dass** es solche der allgemeinen Formel (IV) sind, 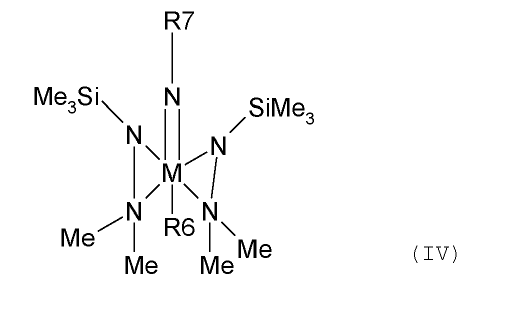 wobei
R⁷ für einen Rest aus der Gruppe der C₁- bis C₅-Alkyl-Reste, gegebenenfalls durch eine bis drei C₁ bis C₅-Alkylgruppen substituierte C₆- C₁₀-Arylreste oder SiR₃ steht, wobei R für **C₁-C₄-Alkyl steht**, und
R⁶ für einen Halogenrest aus der Gruppe Cl, Br, J, für BH₄, für einen gegebenenfalls substituierter Allyl-Rest, für einen Indenyl-Rest, für einen gegebenenfalls substituierten Benzyl-Rest, für einen gegebenenfalls substituierten Cyclopentadienyl-Rest, für einen C₁- bis C₁₂-Oxyalkyl-Rest oder für einen Rest -NR⁹R¹⁰ steht, wobei R⁹ und R¹⁰ unabhängig voneinander für gleiche oder verschiedene gegebenenfalls substituierte C₁-bis C₁₂-Alkyl-, C₅- bis C₁₂-Cycloalkyl-, C₆- bis C₁₀-Aryl-Reste, -SiR₃, wobei R für **C₁-C₄-Alkyl steht,** oder H stehen.

4. Verbindungen gemäß wenigstens einem der Ansprüche 1 bis 3, **dadurch gekennzeichnet, dass** es solche der allgemeinen Formel (V) sind, 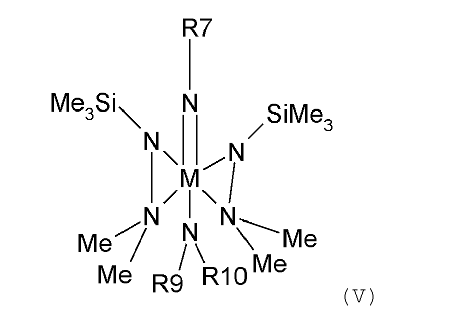 wobei
R⁹ und R¹⁰ unabhängig voneinander für einen gleichen oder verschiedenen Rest aus der Gruppe der C₁- bis C₅-Alkyl-Reste, der gegebenenfalls durch eine bis drei C₁ bis C₅-Alkylgruppen substituierte C₆- C₁₀-Arylreste, SiR₃, wobei R für **C₁-C₄-Alkyl steht, oder H stehen und**
R⁷ für einen Rest aus der Gruppe der C₁- bis C₅-Alkyl-Reste, gegebenenfalls durch eine bis drei C₁ bis C₅-Alkylgruppen substituierte C₆- C₁₀-Arylreste oder SiR₃ steht, wobei R für **C₁-C₄-Alkyl steht.**

5. Verbindungen gemäß wenigstens einem der Ansprüche 1 bis, **dadurch gekennzeichnet, dass** es solche ausgewählt 25 aus den allgemeinen Formeln (VI) bis (X) sind, 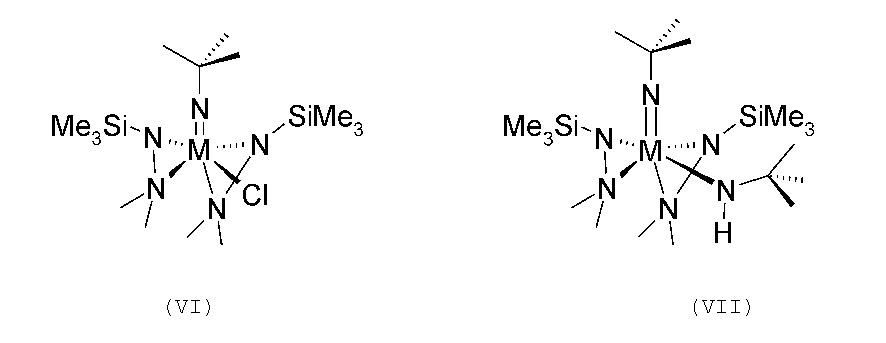 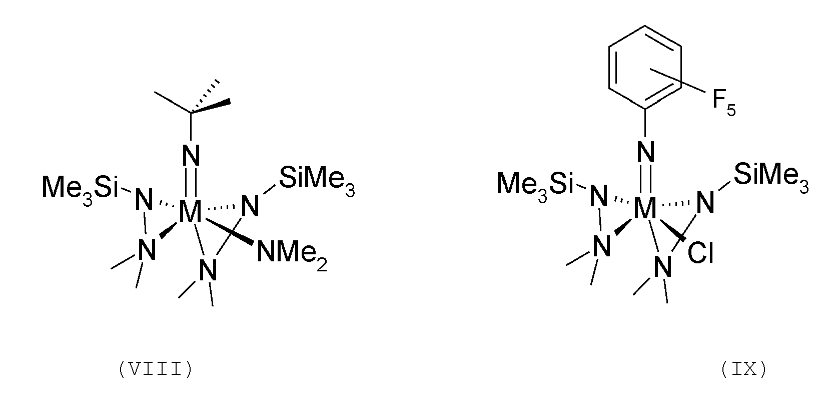 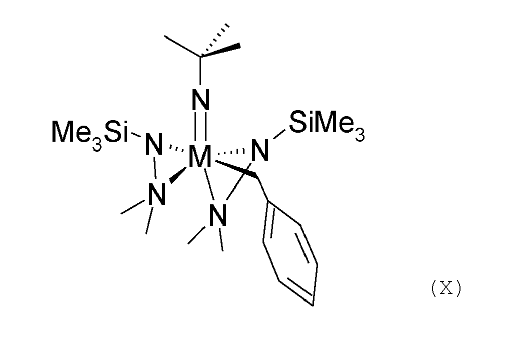 worin M für Ta oder Nb, bevorzugt für Ta steht.

6. Verwendung von Verbindungen gemäß den Ansprüchen 1 bis 5 als Vorläuferverbindung (Prekursor) für die Herstellung Tantal- oder niob-haltiger Schichten mittels des Chemical Vapour Deposition-Verfahrens.

7. Verwendung von Verbindungen gemäß den Ansprüchen 1 bis 5 als Vorläuferverbindung für die Herstellung (Prekursor) für Tantalnitrid-(TaN)-schichten oder Niobnitrid-(NbN)-schichten mittels des Chemical Vapour Deposition-Verfahrens.

## Claims

1. Compounds of the general formula (II) 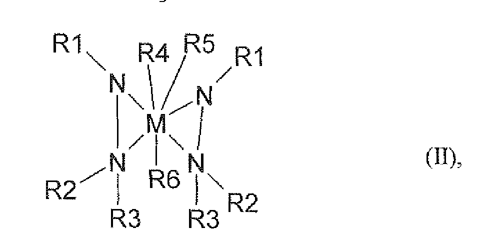 in which
M represents Nb or Ta,
R¹, R² and R³, independently of one another, represent optionally substituted C₁- to C₁₂-alkyl radicals, but not simultaneously methyl radicals, C₅- to C₁₂-cycloalkyl radicals, C₆- to C₁₀-aryl radicals, 1-alkenyl, 2-alkenyl or 3-alkenyl radicals, triorganosilyl radicals -SiR₃, in which R represents C₁- to C₄-alkyl radicals,
R⁴ R⁵, R⁶ represent halogen from the group consisting of Cl, Br and I, represent O-R⁸, in which R⁸ represents an optionally substituted C₁- to C₁₂-alkyl, C₅- to C₁₂-cycloalkyl or C₆- to C₁₀-aryl radical or -SiR₃, represent BH₄, represent an optionally substituted allyl radical, represent an indenyl radical, represent an optionally substituted benzyl radical, represent an optionally substituted cyclopentadienyl radical, represent CH₂SiMe₃, represent a pseudohalide, such as, for example, -N₃, represent silylamide -N(SiMe₃)₂, represent -NR⁹R¹⁰, in which R⁹ and R¹⁰, independently of one another, represent identical or different optionally substituted C₁- to C₁₂-alkyl, C₅- to C₁₂-cycloalkyl or C₆- to C₁₀-aryl radicals, -SiR₃, in which R represents C₁-C₄-alkyl, or H, or represents -NR¹-NR²R³ (hydrazido (1)), in which R¹, R² and R³, independently of one another, have the abovementioned meaning of R¹, R² and R³
or R⁴ and R⁵ together represent =N-R⁷, in which R⁷ represents an optionally substituted C₁- to C₁₂-alkyl, C₅- to C₁₂-cycloalkyl or C₆- to C₁₀-aryl radical or -SiR₃.

2. Compounds according to Claim 1, **characterized in that** they are those of the general formula (III) 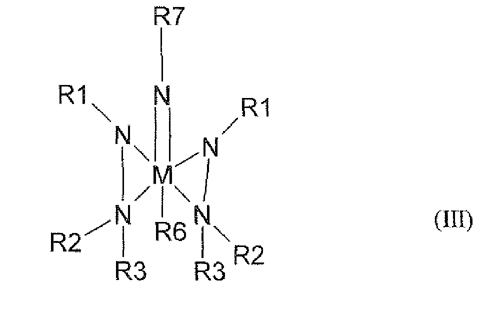 in which
M represents Ta or Nb,
R¹ represents C₁- to C₅-alkyl, C₅- to C₆-cycloalkyl or an optionally substituted phenyl radical or SiR₃, in which R represents C₁-C₄-alkyl,
R² and R³ represent identical C₁- to C₅-alkyl or C₅- to C₆-cycloalkyl radicals or optionally substituted phenyl radicals or SiR₃, in which R represents C₁-C₄-alkyl,
R⁷ represents a C₁- to C₅-alkyl, C₅- to C₆-cycloalkyl or optionally substituted phenyl radical or SiR₃, in which R represents C₁-C₄-alkyl, and
R⁶ represents a halogen radical from the group consisting of Cl, Br and I, represents BH₄, represents an optionally substituted allyl radical, represents an indenyl radical, represents an optionally substituted benzyl radical, represents an optionally substituted cyclopentadienyl radical, represents a C₁- to C₁₂-oxyalkyl radical or represents a radical -NR⁹R¹⁰, in which R⁹ and R¹⁰, independently of one another, represent identical or different optionally substituted C₁- to C₁₂-alkyl, C₅- to C₁₂-cycloalkyl or C₆- to C₁₀-aryl radicals, -SiR₃, in which R represents C₁-C₄-alkyl, or H.

3. Compounds according to Claim 1 or 2, **characterized in that** they are those of the general formula (IV) 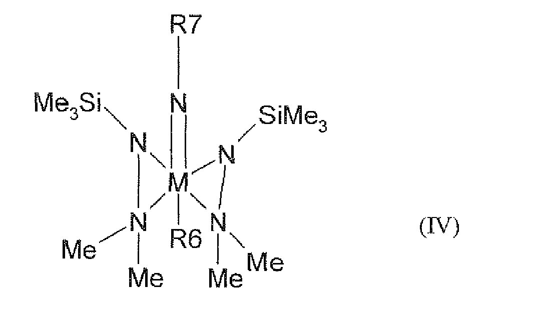 in which
R⁷ represents a radical from the group consisting of the C₁- to C₅-alkyl radicals, the C₆- to C₁₀-aryl radicals optionally substituted by one to three C₁- to C₅-alkyl groups, or SiR₃, in which R represents C₁-C₄- alkyl, and
R⁶ represents a halogen radical from the group consisting of Cl, Br and I, represents BH₄, represents an optionally substituted allyl radical, represents an indenyl radical, represents an optionally substituted benzyl radical, represents an optionally substituted cyclopentadienyl radical, represents a C₁- to C₁₂-oxyalkyl radical or represents a radical -NR⁹R¹⁰, in which R⁹ and R¹⁰, independently of one another, represent identical or different optionally substituted C₁- to C₁₂-alkyl, C₅- to C₁₂-cycloalkyl or C₆- to C₁₀-aryl radicals, -SiR₃, in which R represents C₁-C₄-alkyl, or H.

4. Compounds according to at least one of Claims 1 to 3, **characterized in that** they are those of the general formula (V) 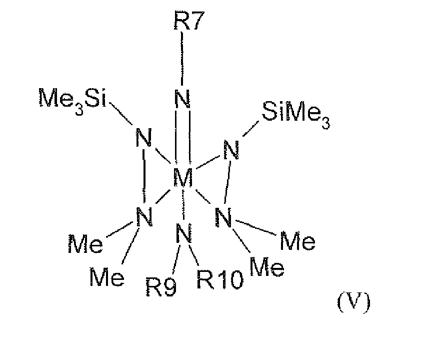 in which
R⁹ and R¹⁰, independently of one another, represent an identical or different radical from the group consisting of the C₁- to C₅-alkyl radicals, C₆-C₁₀-aryl radicals optionally substituted by one to three C₁-C₅-alkyl groups, or SiR₃, in which R represents C₁-C₄- alkyl, or H and
R⁷ represents a radical from the group consisting of the C₁- to C₅-alkyl radicals, C₆-C₁₀-aryl radicals optionally substituted by one to three C₁- to C₅-alkyl groups, or SiR₃, in which R represents C₁-C₄-alkyl.

5. Compounds according to at least one of Claims 1 to 4, **characterized in that** they are those selected from the general formulae (VI) to (X) 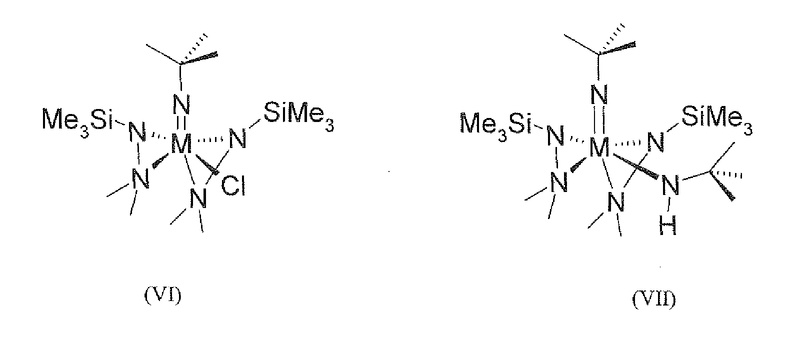 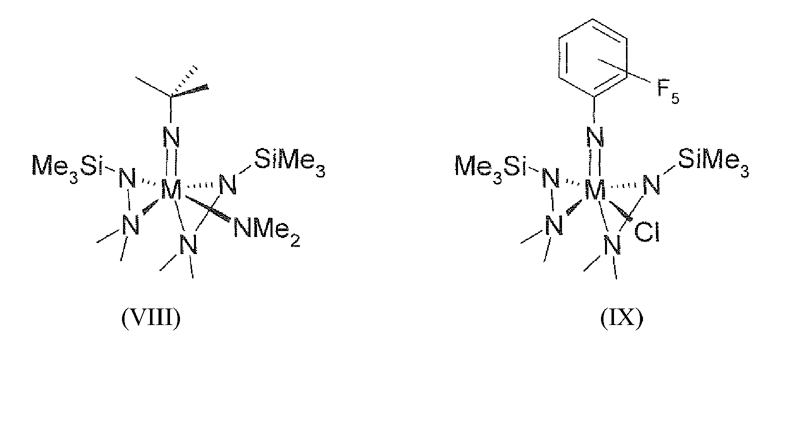 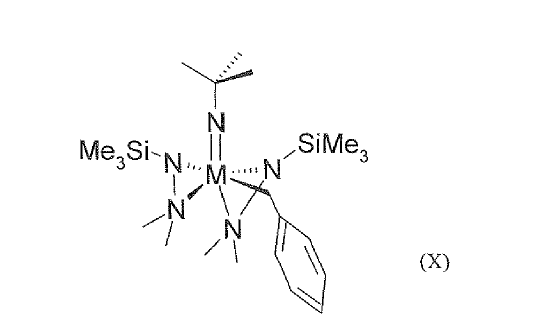 in which M represents Ta or Nb, preferably represents Ta.

6. Use of compounds according to Claims 1 to 5 as a precursor for the production of tantalum- or niobium-containing layers by means of the chemical vapour deposition process.

7. Use of compounds according to Claims 1 to 5 as a precursor for the production of tantalum nitride (TaN) layers or niobium nitride (NbN) layers by means of the chemical vapour deposition process.

## Revendications

1. Composés de formule générale (II) 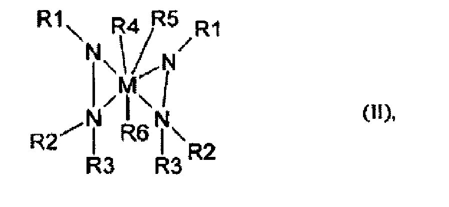
M représente Nb ou Ta,
R¹, R² et R³ représentent, indépendamment l'un de l'autre, un radical, le cas échéant substitué, C₁-C₁₂-alkyle, mais sans représenter simultanément méthyle, C₅-C₁₂-cycloalkyle, C₆-C₁₀-aryle, 1-alcényle, 2-alcényle, 3-alcényle ou triorganosilyle -SiR₃, où R représente un radical C₁-C₄-alkyle,
R⁴, R⁵, R⁶ représentent halogène du groupe Cl, Br, I, représentent O-R⁸, où R⁸ représente un radical, le cas échéant substitué, C₁-C₁₂-alkyle, C₅-C₁₂-cycloalkyle, C₆-C₁₀-aryle ou -SiR₃, représentent BH₄, un radical allyle le cas échéant substitué, un radical indényle, un radical benzyle le cas échéant substitué, un radical cyclopentadiényle le cas échéant substitué, CH₂SiMe₃, un pseudohalogénure, tel que par exemple -N₃, représentent silylamide -N(SiMe₃)₂, -NR⁹R¹⁰, où R⁹ et R¹⁰ représentent, indépendamment l'un de l'autre, des radicaux, identiques ou différents, le cas échéant substitués, C₁-C₁₂-alkyle, C₅-C₁₂-cycloalkyle, C₆-C₁₀-aryle, -SiR₃, où R représente C₁-C₄-alkyle ou H, ou représentent -NR¹-NR²R³ (hydrazido (I)), où R¹, R² et R³, indépendamment l'un de l'autre, présentent la signification susmentionnée de R¹, R² et R³
ou R⁴ et R⁵ représentent, ensemble, =N-R⁷, où R⁷ représente un radical, le cas échéant substitué, C₁-C₁₂-alkyle, C₅-C₁₂-cycloalkyle ou C₆-C₁₀-aryle ou -SiR₃.

2. Composés selon la revendication 1, **caractérisés en ce qu'**il s'agit de composés de formule générale (III), 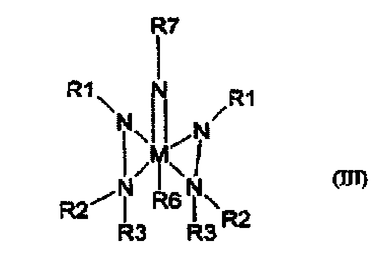 où
A représente Ta ou Nb,
R¹ représente un radical C₁-C₅-alkyle, C₅-C₆-cycloalkyle ou phényle le cas échéant substitué, ou SiR₃, où R représente C₁-C₄-alkyle,
R₂ et R₃ représentent des radicaux C₁-C₅-alkyle ou C₅-C₆-cycloalkyle identiques ou des radicaux phényle le cas échéant substitués, ou SiR₃ où R représente C₁-C₄-alkyle,
R⁷ représente un radical C₁-C₅-alkyle, C₅-C₆-cycloalkyle ou phényle le cas échéant substitué, ou SiR₃, où R représente C₁-C₄-alkyle, et
R⁶ représente un radical halogéno du groupe Cl, Br, I, représente BH₄, représente un radical allyle le cas échéant substitué, représente un radical indényle, un radical benzyle le cas échéant substitué, représente un radical cyclopentadiényle le cas échéant substitué, représente un radical C₁-C₁₂-oxyalkyle ou un radical -NR⁹R¹⁰, où R⁹ et R¹⁰, indépendamment l'un de l'autre, représentent des radicaux, identiques ou différents, le cas échéant substitués, C₁-C₁₂-alkyle, C₅-C₁₂-cycloalkyle, C₆-C₁₀-aryle, SiR₃, où R représente C₁-C₄-alkyle, ou H.

3. Composés selon la revendication 1 ou 2,
**caractérisés en ce qu'**il s'agit de composés de formule générale (IV), 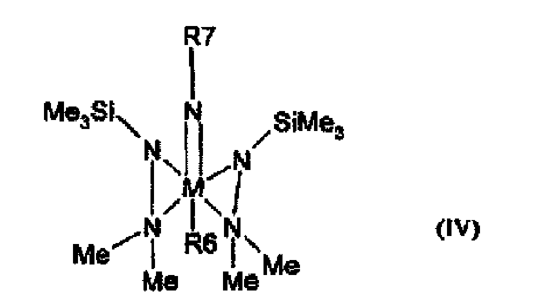 où
R⁷ représente un radical du groupe des radicaux C₁-C₅-alkyle, des radicaux C₆-C₁₀-aryle le cas échéant substitués par un à trois groupes C₁-C₅-alkyle ou SiR₃, où R représente C₁-C₄-alkyle, et
R⁶ représente un radical halogéno du groupe Cl, Br, I, représente BH₄, représente un radical allyle le cas échéant substitué, représente un radical indényle, un radical benzyle le cas échéant substitué, représente un radical cyclopentadiényle le cas échéant substitué, représente un radical C₁-C₁₂-oxyalkyle ou un radical -NR⁹R¹⁰, où R⁹ et R¹⁰, indépendamment l'un de l'autre, représentent des radicaux, identiques ou différents, le cas échéant substitués, C₁-C₁₂₋alkyle, C₅-C₁₂-cycloalkyle, C₆-C₁₀-aryle, SiR₃, où R représente C₁-C₄-alkyle, ou H.

4. Composés selon au moins l'une quelconque des revendications 1 à 3, **caractérisés en ce qu'**il s'agit de composés de formule générale (V), 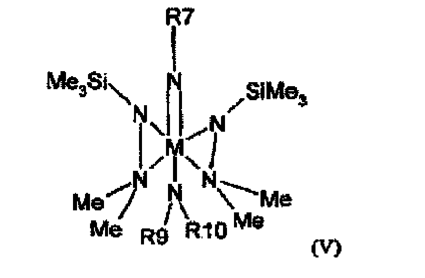 où
R⁹ et R¹⁰ indépendamment l'un de l'autre, représentent un radical, identique ou différent, du groupe des radicaux C₁-C₅-alkyle, des radicaux C₆-C₁₀-aryle le cas échéant substitués par un ou trois groupes C₁-C₅-alkyle, SiR₃, où R représente C₁-C₄-alkyle, ou H et
R⁷ représente un radical du groupe des radicaux C₁-C₅-alkyle, des radicaux C₆-C₁₀-aryle le cas échéant substitués par un à trois groupes C₁-C₅-alkyle ou SiR₃, où R représente C₁-C₄-alkyle.

5. Composés selon au moins l'une quelconque des revendications 1 à 4, **caractérisés en ce qu'**il s'agit de composés choisis parmi les formules générales (VI) à (X) , 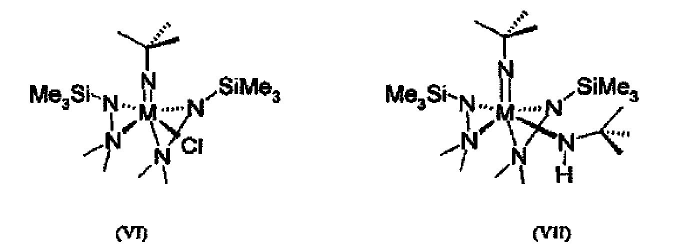 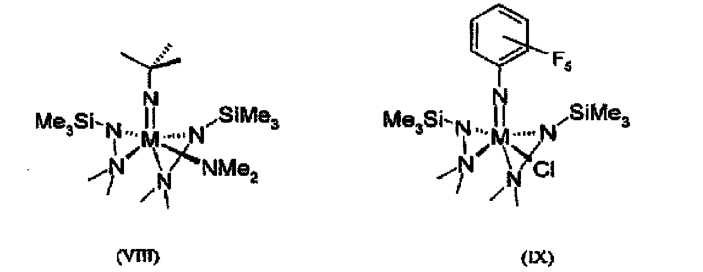 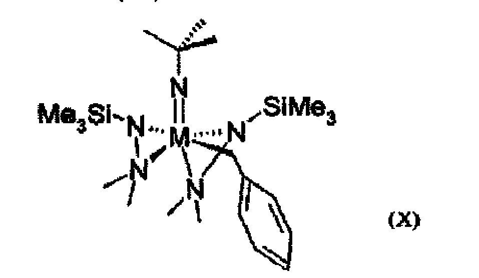 où M représente Ta ou Nb, de préférence Ta.

6. Utilisation de composés selon l'une quelconque des revendications 1 à 5 comme composé précurseur pour la préparation de couches contenant du tantale ou du niobium au moyen du procédé de dépôt par vapeur chimique ("Chemical Vapour Deposition").

7. Utilisation de composes selon l'une quelconque des revendications 1 à 5 comme compose precurseur pour la preparation de couches de nitrure de tantale (TaN) ou de nitrure de niobium (NbN) au moyen du procédé de dépôt par vapeur chimique ("Chemical Vapour Deposition").
